# EUROPEAN PATENT APPLICATION

(11) **EP 4 593 559 A1**
(43) Date of publication of application: **30.07.2025**
(21) Application number: 24214729.6
(22) Date of filing: 22.11.2024
(51) Int. Cl.: H10F 39/00

(54) **IMAGE SENSOR HAVING PATTERNED ANTI-REFLECTION LAYER AND ELECTRONIC APPARATUS INCLUDING THE SAME**

(30) Priority: 24.01.2024 KR 20240010995; 03.09.2024 KR 20240119570
(71) Applicant: Samsung Electronics Co., Ltd., Suwon-si, Gyeonggi-do 16677 (KR)
(72) Inventor: CHO, Choonlae, 16678 Suwon-si (KR); AHN, Sungmo, 16678 Suwon-si (KR); ROH, Sookyoung, 16678 Suwon-si (KR); PARK, Hyeonsoo, 16678 Suwon-si (KR); PARK, Hongkyu, 16678 Suwon-si (KR)
(74) Representative: Elkington and Fife LLP

(57) **Abstract**

Provided is an image sensor including a sensor substrate including a plurality of pixels configured to sense light, the plurality of pixels being are two-dimensionally provided, a nano-photonic lens array including a plurality of meta-regions respectively corresponding to the plurality of pixels, and an anti-reflection layer on a light incident surface of the nano-photonic lens array, the anti-reflection layer being configured to reduce a reflection loss and including a plurality of nano-patterns that are periodically and two-dimensionally provided, wherein the plurality of meta-regions include a plurality of nano-structures configured to color-separate light that is incident on the nano-photonic lens array and focus the light onto each of the plurality of pixels.

## Description

### FIELD OF THE INVENTION

Embodiments of the present disclosure relate to an image sensor having a patterned anti-reflection layer and an electronic apparatus including the image sensor.

### BACKGROUND OF THE INVENTION

Image sensors may sense the color of incident light by using a color filter. However, a color filter may have a relatively low light utilization efficiency because the color filter absorbs light of colors other than the intended color of light. For example, in the case in which a red-green-blue (RGB) color filter is used, only 1/3 of the incident light is transmitted therethrough and the other part of the incident light, that is, 2/3 of the incident light, is absorbed. Thus, the light utilization efficiency is only about 33%. Thus, in a color display apparatus or a color image sensor, most light loss occurs in the color filter. Also, an image sensor includes multiple layers having different refractive indices from one another, and thus, incident light may be reflected by an interfacial layer. In order to improve the light utilization efficiency of image sensors, the image sensors need to have low reflectivity with respect to incident light.

### SUMMARY OF THE INVENTION

One or more embodiments provide an image sensor having a patterned anti-reflection layer and an electronic apparatus including the image sensor.

Additional aspects will be set forth in part in the description which follows and, in part, will be apparent from the description, or may be learned by practice of one or more embodiments.

According to an aspect of one or more embodiments, there is provided an image sensor including a sensor substrate including a plurality of pixels configured to sense light, the plurality of pixels being are two-dimensionally provided, a nano-photonic lens array including a plurality of meta-regions respectively corresponding to the plurality of pixels, and an anti-reflection layer on a light incident surface of the nano-photonic lens array, the anti-reflection layer being configured to reduce a reflection loss and including a plurality of nano-patterns that are periodically and two-dimensionally provided, wherein the plurality of meta-regions include a plurality of nano-structures configured to color-separate light that is incident on the nano-photonic lens array and focus the light onto each of the plurality of pixels, and wherein, when a distance between a first nano-structure, from among the plurality of nano-structures, and a first nano-pattern, from among the plurality of nano-patterns, closest to the first nano-structure is g1 and a distance between a second nano-structure, from among the plurality of nano-structures, different from the first nano-structure, and a second nano-pattern, from among the plurality of nano-patterns, closest to the second nano-structure is g2, |g1 - g2|=Δg satisfies a condition Δg ≤ T/4, where T denotes an arrangement period of the plurality of nano-patterns.

According to proposed embodiments, there may be provided a patterned anti-reflection layer for reducing the reflectivity of image sensors.

Embodiments relate to a patterned reflection reduction layer formed on top of a CIS to reduce reflectivity in an image sensor applied with a meta-optical structure, and to a position compensation method for improving artifacts caused by interference between an arrangement of color-splitting meta-optical structures and an arrangement of reflection reduction layer patterns.

Proposals may relate to a method for moving a pattern of a reflection reduction layer according to a position on a CIS in order to prevent the occurrence of interference patterns due to the reflection reduction layer and the lower color-splitting meta-optical structure in an image sensor to which a meta-optical structure and a patterned reflection reduction layer are applied. As the reflection reduction layer moves along with the shrinking of the meta-optical structure from the center of the image sensor to the periphery, even if the relative positions of the two optical structures shift, a cycle such as an interference pattern does not occur and monotonically increases or monotonically decreases.

According to embodiment, in an image sensor applied with a meta-optical structure, comprising a reflection reduction layer may be formed on top of the meta-optical structure in which holes or posts are arranged with a period T, and shrink may be applied so that the positional difference between the reflection reduction layer and the meta-optical structure occurs less than T/2 over the entire area of the image sensor. The period T of the reflection reduction layer may be 100 nm or more. Also, when the meta-optical structure is composed of multiple layers, shrink may be applied so that the position difference is T/2 or less based on the reflection reduction layer and the adjacent layer. Further, the reflection reduction layer may be composed of a unit structure of a period such as a unit pixel, which may be composed of holes or posts of different sizes randomly, or which may be configured at random positions so as not to be correctly positioned in the array.

At a center portion of the nano-photonic lens array, g1 may be 0.

At a center portion of the nano-photonic lens array, the first nano-structure and the first nano-pattern closest to the first nano-structure may be arranged such that the first nano-structure and the first nano-pattern do not overlap each other.

The first nano-structure may be at a center portion of the nano-photonic lens array and g1 is T/2.

Δg may be 0 with respect to an entire area of the nano-photonic lens array.

The first nano-structure may be at a center portion of the nano-photonic lens array where incident light is perpendicularly incident, the second nano-structure may be at a periphery portion of the nano-photonic lens array where the incident light is obliquely incident, and wherein g1 may be different from g2.

At a center portion of the nano-photonic lens array where incident light is perpendicularly incident, the plurality of pixels and the plurality of meta-regions corresponding to each other may be matched, and at a periphery portion of the nano-photonic lens array where the incident light is obliquely incident, the plurality of meta-regions may be shifted toward the center portion of the nano-photonic lens array with respect to corresponding pixels from among the plurality of pixels.

At the periphery portion of the nano-photonic lens array, the plurality of nano-patterns of the anti-reflection layer may be shifted toward the center portion of the nano-photonic lens array, and a deviation between a shifted distance of the plurality of meta-regions and a shifted distance of the plurality of nano-patterns may be within ±1/4 of the arrangement period of the plurality of nano-patterns.

In the entire area of the nano-photonic lens array, the shifted distance of the plurality of meta-regions and a shifted distance of the plurality of nano-patterns may be equal to each other.

A pitch between the plurality of nano-structures may be equal to a pitch between the plurality of nano-patterns.

The image sensor may further include a color filter layer between the sensor substrate and the nano-photonic lens array, and a planarization layer between the color filter layer and the nano-photonic lens array.

The color filter layer may include a first color filter configured to transmit light of a first wavelength, a second color filter configured to transmit light of a second wavelength that is different from the first wavelength, a third color filter configured to transmit light of a third wavelength that is different from the first wavelength and the second wavelength, and a fourth color filter configured to transmit light of the first wavelength, the plurality of pixels may include a first pixel corresponding to the first color filter, a second pixel corresponding to the second color filter, a third pixel corresponding to the third color filter, and a fourth pixel corresponding to the fourth color filter, and the plurality of meta-regions may include a first meta-region corresponding to the first pixel, a second meta-region corresponding to the second pixel, a third meta-region corresponding to the third pixel, and a fourth meta-region corresponding to the fourth pixel.

At a center portion of the nano-photonic lens array where incident light is perpendicularly incident, a boundary of the first pixel, a boundary of the first color filter, and a boundary of the first meta-region corresponding to one another may be matched, a boundary of the second pixel, a boundary of the second color filter, and a boundary of the second meta-region corresponding to one another may be matched, a boundary of the third pixel, a boundary of the third color filter, and a boundary of the third meta-region corresponding to one another may be matched, and a boundary of the fourth pixel, a boundary of the fourth color filter, and a boundary of the fourth meta-region corresponding to one another may be matched, and at a periphery portion of the nano-photonic lens array where the incident light is obliquely incident, the first color filter, the second color filter, the third color filter, and the fourth color filter may be shifted toward the center portion of the nano-photonic lens array by a first distance with respect to the first pixel, the second pixel, the third pixel, and the fourth pixel corresponding to the first color filter, the second color filter, the third color filter, and the fourth color filter, respectively, and the first meta-region, the second meta-region, the third meta-region, and the fourth meta-region may be shifted toward the center portion of the nano-photonic lens array by a second distance that is greater than the first distance with respect to the first pixel, the second pixel, the third pixel, and the fourth pixel corresponding to the first meta-region, the second meta-region, the third meta-region, and the fourth meta-region, respectively.

At the periphery portion of the nano-photonic lens array, the plurality of nano-patterns may be shifted toward the center portion of the nano-photonic lens array by a third distance, and in the entire area of the nano-photonic lens array, a condition d2 - T/4 ≤ d3 ≤ d2 + T/4 may be satisfied, where d2 denotes the second distance and d3 denotes the third distance.

Each nano-structure of the plurality of nano-structures may include a first nano-structure layer and a second nano-structure layer on the first nano-structure layer, and g1 corresponds to a distance between the first nano-structure and the first nano-pattern included in the second nano-structure layer and g2 corresponds to a distance between the second nano-structure and the second nano-pattern included in the second nano-structure layer.

At a periphery portion of the nano-photonic lens array where incident light is obliquely incident, the second nano-structure layer may be shifted toward a center portion of the nano-photonic lens array.

The anti-reflection layer may include a first anti-reflection layer and a second anti-reflection layer on the first anti-reflection layer, the first anti-reflection layer may be a film structure and is on the nano-photonic lens array, and the second anti-reflection layer may include the plurality of nano-patterns.

The anti-reflection layer further may include a dielectric layer that is transparent with respect to visible ray, and the plurality of nano-patterns may include holes formed through the dielectric layer.

The arrangement period of the plurality of nano-patterns may be 150 nm to 300 nm, and a width or a diameter of each of the plurality of nano-patterns may be 60% to 90% of the arrangement period of the plurality of nano-patterns.

According to another aspect of one or more embodiments, there is provided an electronic apparatus including a lens assembly configured to form an optical image of a subject, an image sensor configured to convert the optical image formed by the lens assembly into an electrical signal, and at least one processor configured to process the electrical signal generated by the image sensor, wherein the image sensor includes a sensor substrate including a plurality of pixels configured to sense light, the plurality of pixels being are two-dimensionally provided, a nano-photonic lens array including a plurality of meta-regions respectively corresponding to the plurality of pixels, and an anti-reflection layer on a light incident surface of the nano-photonic lens array, the anti-reflection layer being configured to reduce a reflection loss and including a plurality of nano-patterns that are periodically and two-dimensionally provided, wherein the plurality of meta-regions include a plurality of nano-structures configured to color-separate light that is incident on the nano-photonic lens array and focus the light onto each of the plurality of pixels, and wherein, when a distance between a first nano-structure, from among the plurality of nano-structures, and a first nano-pattern, from among the plurality of nano-patterns, closest to the first nano-structure is g1 and a distance between a second nano-structure, from among the plurality of nano-structures, different from the first nano-structure, and a second nano-pattern, from among the plurality of nano-patterns, closest to the second nano-structure is g2, |g1 - g2|=Δg satisfies a condition Δg ≤ T/4, where T denotes an arrangement period of the plurality of nano-patterns.

According to still another aspect of one or more embodiments, there is provided an image sensor including a sensor substrate including a plurality of pixels configured to sense light, the plurality of pixels being are two-dimensionally provided, a nano-photonic lens array including a plurality of meta-regions respectively corresponding to the plurality of pixels, and an anti-reflection layer on a light incident surface of the nano-photonic lens array, the anti-reflection layer being configured to reduce a reflection loss and including a plurality of nano-patterns that are periodically and two-dimensionally provided, wherein the plurality of meta-regions include a plurality of nano-structures configured to color-separate light that is incident on the nano-photonic lens array and focus the light onto each of the plurality of pixels, wherein, when a distance between a first nano-structure, from among the plurality of nano-structures, and a first nano-pattern, from among the plurality of nano-patterns, closest to the first nano-structure is g1 and a distance between a second nano-structure, from among the plurality of nano-structures, different from the first nano-structure, and a second nano-pattern, from among the plurality of nano-patterns, closest to the second nano-structure is g2, |g1 - g2|=Δg satisfies a condition Δg ≤ T/4, where T denotes an arrangement period of the plurality of nano-patterns, and wherein, at a periphery portion of the nano-photonic lens array where incident light is obliquely incident, the plurality of meta-regions and the plurality of nano-patterns of the anti-reflection layer are shifted toward a center portion of the nano-photonic lens array with respect to corresponding pixels from among the plurality of pixels.

### BRIEF DESCRIPTION OF DRAWINGS

The above and other aspects, features, and advantages of one or more embodiments will be more apparent from the following description taken in conjunction with the accompanying drawings, in which:
FIG. 1 is a block diagram of an image sensor according to one or more embodiments;
FIGS. 2A, 2B, and 2C are diagrams showing examples of various pixel arrangements in a pixel array of an image sensor;
FIG. 3 is a perspective view schematically showing a structure of a pixel array in an image sensor according to one or more embodiments;
FIG. 4 is a plan view schematically showing a structure of a sensor substrate in the pixel array of FIG. 3;
FIG. 5 is a plan view schematically showing a structure of a color filter layer of FIG. 3;
FIG. 6 is a plan view showing an example of the nano-photonic lens array of FIG. 3;
FIG. 7 is a diagram showing an example of phase profiles of green light and blue light after passing through a nano-photonic lens array;
FIG. 8 is a diagram showing an example of phase profiles of red light and green light after passing through a nano-photonic lens array;
FIG. 9 is a plan view showing an example of the anti-reflection layer of FIG. 3;
FIG. 10 is a diagram showing an example of locations of a center portion and a periphery portion of a pixel array having different chief ray angles (CRA) of incident light;
FIG. 11 is a cross-sectional view schematically showing a cross-sectional structure of a pixel array at the center portion of a pixel array according to one or more embodiments;
FIG. 12 is a diagram showing an example of relative positions between a nano-structure in a nano-photonic lens array and a nano-pattern of an anti-reflection layer in the center portion of a pixel array according to one or more embodiments;
FIG. 13 is a cross-sectional view schematically showing a cross-sectional structure of a pixel array at the periphery portion of a pixel array according to one or more embodiments;
FIG. 14 is a diagram showing an example of relative positions between a nano-structure in a nano-photonic lens array and a nano-pattern of an anti-reflection layer at a first position in the periphery portion of a pixel array according to one or more embodiments;
FIG. 15 is a diagram showing an example of relative positions between a nano-structure in a nano-photonic lens array and a nano-pattern of an anti-reflection layer at a second position in the periphery portion of a pixel array according to one or more embodiments;
FIG. 16 is a diagram showing an example of relative positions between a nano-structure in a nano-photonic lens array and a nano-pattern of an anti-reflection layer in the center portion of a pixel array according to one or more other embodiments;
FIG. 17 is a diagram showing an example of relative locations of a nano-structure in a nano-photonic lens array and a nano-pattern of an anti-reflection layer at a first position in the periphery portion of a pixel array according to one or more other embodiments;
FIG. 18 is a diagram showing an example of relative locations of a nano-structure in a nano-photonic lens array and a nano-pattern of an anti-reflection layer at a second position in the periphery portion of a pixel array according to one or more other embodiments;
FIG. 19 is a cross-sectional view schematically showing a cross-sectional structure of a pixel array at the center portion of a pixel array according to one or more other embodiments;
FIG. 20 is a cross-sectional view schematically showing a cross-sectional structure of a pixel array at the periphery portion of a pixel array according to one or more other embodiments;
FIG. 21 is a cross-sectional view schematically showing a cross-sectional structure of a pixel array at the center portion of a pixel array according to one or more other embodiments;
FIG. 22 is a block diagram of an electronic apparatus including an image sensor according to one or more embodiments;
FIG. 23 is a block diagram of a camera module in FIG. 22;
FIG. 24 is a block diagram of an electronic device including a multi-camera module; and
FIG. 25 is a detailed block diagram of the multi-camera module in the electronic device of FIG. 24.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, an image sensor including a patterned anti-reflection layer and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or an operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

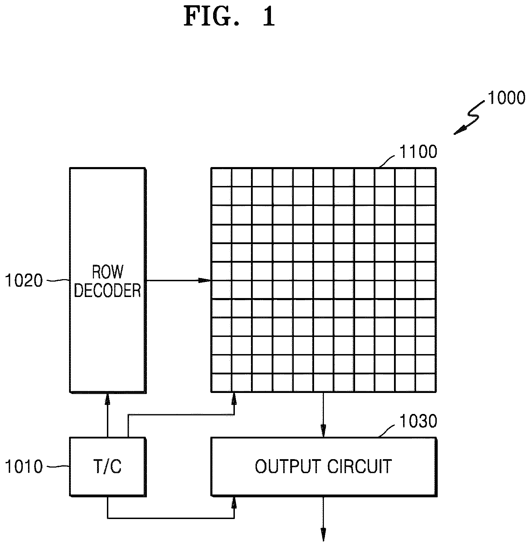

FIG. 1 is a schematic block diagram of an image sensor 1000 according to one or more embodiments. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal from a plurality of pixels disposed in the selected row in a column unit. To this end, the output circuit 1030 may include a column decoder and an analog-to-digital converter (ADC). For example, the output circuit 1030 may include a plurality of ADCs that are respectively disposed in columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

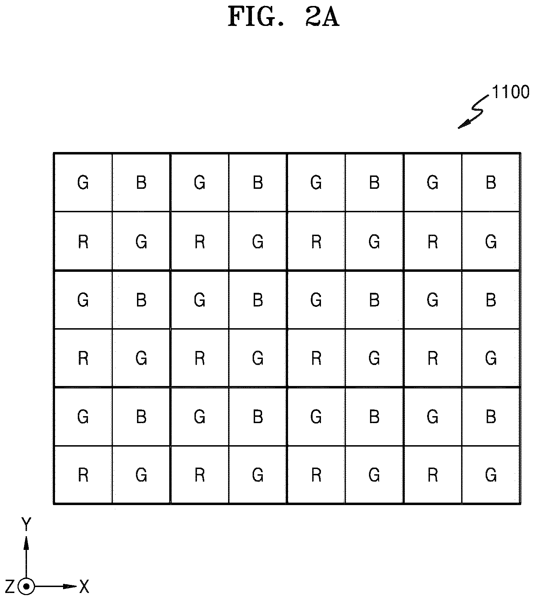

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

FIG. 2A shows a Bayer pattern that is generally used in the image sensor 1000. Referring to FIG. 2A, one unit pattern includes four quadrant regions, wherein first through fourth quadrants may be a blue pixel B, a green pixel G, a red pixel R, and a green pixel G, respectively. The unit patterns may be repeatedly and two-dimensionally disposed in a first direction (X direction) and a second direction (Y direction). For example, two green pixels G are disposed in one diagonal direction and one blue pixel B and one red pixel R are disposed in another diagonal direction in a unit pattern of a 2×2 array. In the entire arrangement of pixels, a first row in which a plurality of green pixels G and a plurality of blue pixels B are alternately disposed in the first direction and a second row in which a plurality of red pixels R and a plurality of green pixels G are alternately disposed in the first direction are repeatedly disposed in a second direction.

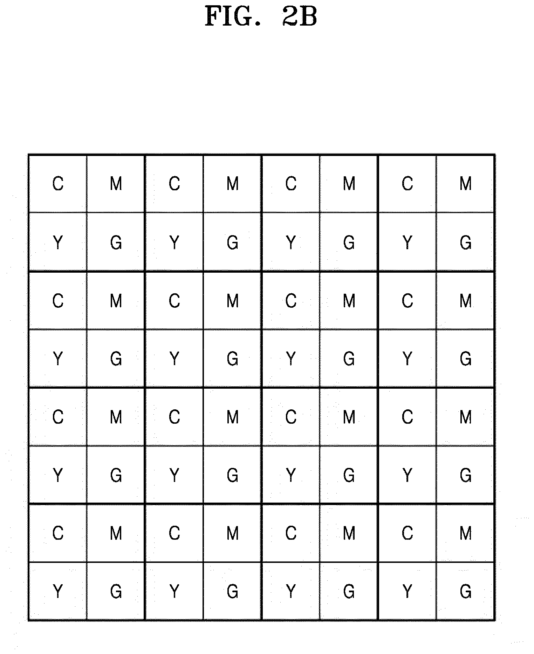

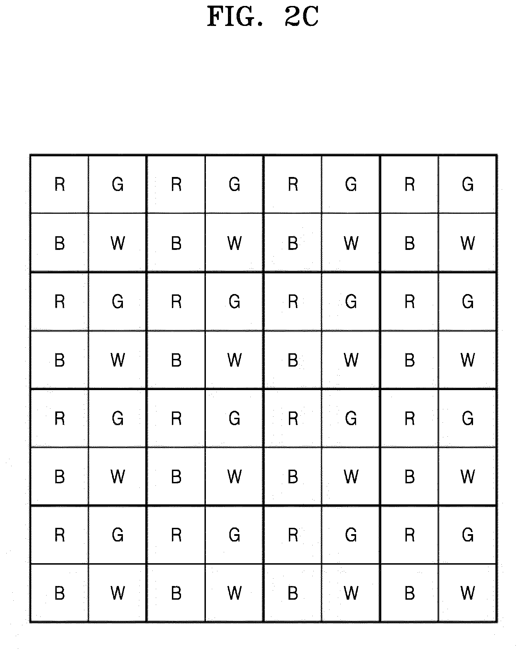

The pixel array 1100 may have various arrangement patterns, rather than the Bayer pattern. For example, referring to FIG. 2B, a CYGM arrangement, in which a magenta pixel M, a cyan pixel C, a yellow pixel Y, and a green pixel G configure one unit pattern, may be used. Also, referring to FIG. 2C, an RGBW arrangement, in which a green pixel G, a red pixel R, a blue pixel, and a white pixel W configure one unit pattern, may be used. The unit pattern may have a 3×2 array form. In addition to the above examples, the pixels in the pixel array 1100 may be disposed in various ways according to color characteristics of the image sensor 1000. Hereinafter, it will be described that the pixel array 1100 of the image sensor 1000 has a Bayer pattern, but the operating principles may be applied to other patterns of pixel arrangement than the Bayer pattern.

Hereinafter, for convenience of description, an example in which the pixel array 1100 has a Bayer pattern structure will be described as an example.

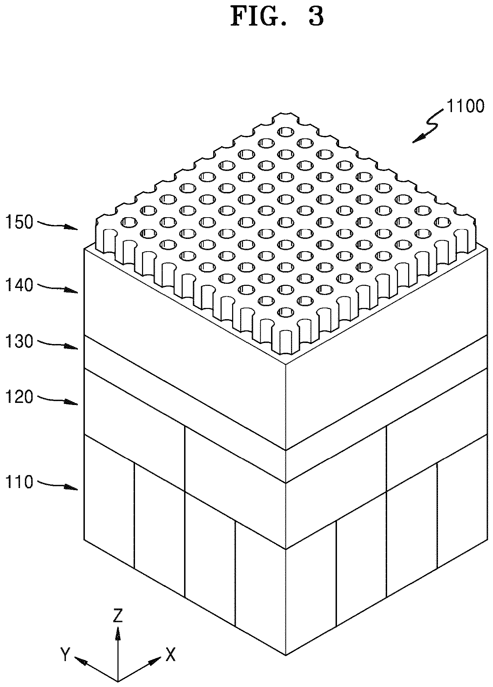

FIG. 3 is a perspective view schematically showing a structure of a pixel array 1100 in an image sensor according to one or more embodiments. Referring to FIG. 3, the pixel array 1100 may include a sensor substrate 110, a color filter layer 120 disposed on the sensor substrate 110, a planarization layer 130 disposed on the color filter layer 120, a nano-photonic lens array 140 disposed on the planarization layer 130, and an anti-reflection layer 150 disposed on the nano-photonic lens array 140. The color filter layer 120 may be disposed between the sensor substrate 110 and the nano-photonic lens array 140, and the planarization layer 130 may be disposed between the color filter layer 120 and the nano-photonic lens array 140.

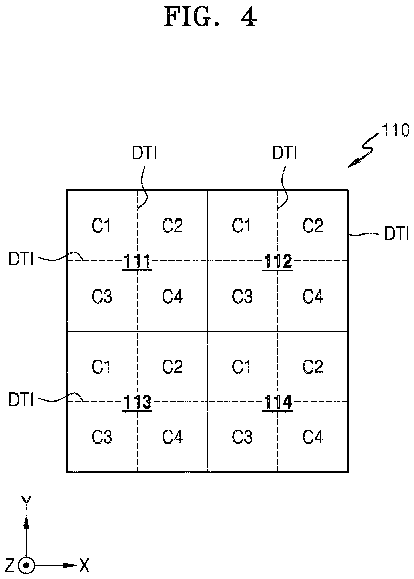

FIG. 4 is a plan view schematically showing a structure of the sensor substrate 110 in the pixel array 1100 of FIG. 3. Referring to FIG. 4, the sensor substrate 110 may include a plurality of pixels sensing incident light. For example, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit pixel pattern. The unit pixel pattern may include, for example, a Bayer pattern. For example, the first and fourth pixels 111 and 114 may be green pixels sensing green light, the second pixel 112 may be a blue pixel sensing blue light, and the third pixel 113 may be a red pixel sensing red light.

FIGS. 3 and 4 only show one unit pixel pattern including four pixels as an example, but the pixel array 1100 may include a plurality of pixel patterns that are two-dimensionally arranged. For example, a plurality of first pixels 111 and a plurality of second pixels 112 may be alternately arranged in a first direction (X-direction), and a plurality of third pixels 113 and a plurality of fourth pixels 114 may be alternately arranged in the first direction (X-direction) on a cross-section located differently in a second direction (Y-direction) perpendicular to the first direction (X-direction). Therefore, the plurality of first pixels 111, the plurality of second pixels 112, the plurality of third pixels 113, and the plurality of fourth pixels 114 may be two-dimensionally arranged in the first direction and the second direction.

Each of the first to fourth pixels 111, 112, 113, and 114 may include a plurality of photosensitive cells that independently sense incident light. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally arranged in the first direction (X-direction) and the second direction (Y-direction). For example, in each of the first to fourth pixels 111, 112, 113, and 114, the first to fourth photosensitive cells C1, C2, C3, and C4 may be disposed in a 2x2 array.

FIG. 4 shows an example in which each of the first to fourth pixels 111, 112, 113, and 114 includes four photosensitive cells, but four or more independent photosensitive cells may be grouped and two-dimensionally disposed. For example, each of the first to fourth pixels 111, 112, 113, and 114 may include a plurality of independent photosensitive cells that are grouped and arranged in a 3x3 array or a 4x4 array. Hereinafter, an example in which each of the first to fourth pixels 111, 112, 113, and 114 includes the photosensitive cells arranged in a 2x2 array will be described for convenience of description.

According to the one or more embodiments, an auto-focusing signal may be obtained from a difference between output signals of adjacent photosensitive cells. For example, an auto-focusing signal in the first direction (X-direction) may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an auto-focusing signal in the second direction (Y-direction) may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

In addition, a general image signal may be obtained by summing output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

Also, each of the first to fourth pixels 111, 112, 113, and 114 may include isolations DTI that electrically isolate the plurality of photosensitive cells from one another. The isolation DTI may have, for example, a deep trench isolation structure. The deep trench may be filled with air or an electrically insulating material. The isolations DTI may extend in the first direction (X-direction) and the second direction (Y-direction) to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolations DTI. The isolation DTI extending in the first direction (X-direction) and the isolation DTI extending in the second direction (Y-direction) may cross each other at the center of each of the first to fourth pixels 111, 112, 113, and 114.

Also, the isolations DTI may be arranged in the first direction (X-direction) and the second direction (Y-direction) between adjacent pixels from among the first to fourth pixels 111, 112, 113, and 114. Therefore, the first to fourth pixels 111, 112, 113, and 114 may be isolated from one another due to the isolations DTI. The isolation DTI extending in the first direction (X-direction) and the isolation DTI extending in the second direction (Y-direction) may cross each other at the center of the unit pixel pattern including the first to fourth pixels 111, 112, 113, and 114.

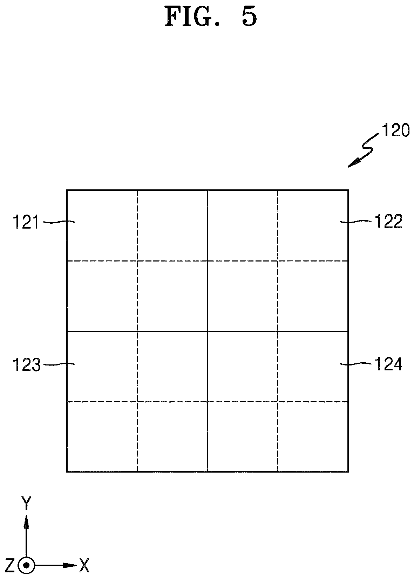

FIG. 5 is a plan view schematically showing a structure of the color filter layer 120 of FIG. 3. Referring to FIG. 5, the color filter layer 120 may include a plurality of color filters each transmitting light of a certain wavelength and absorbing light of wavelength other than the certain wavelength. For example, the color filter layer 120 may include a first color filter 121 transmitting light of a first wavelength band and absorbing light of wavelength band other than the first wavelength, a second color filter 122 transmitting light of a second wavelength band that is different from the first wavelength band and absorbing light of wavelength band other than the second wavelength, a third color filter 123 transmitting light of a third wavelength band that is different from the first and second wavelength bands and absorbing light of wavelength band other than the third wavelength, and a fourth color filter 124 transmitting light of the first wavelength band and absorbing light of wavelength band other than the first wavelength. FIG. 5 only shows one unit color pattern, but a plurality of first color filters 121 and a plurality of second color filters 122 may be alternately arranged in the first direction (X-direction), and a plurality of third color filters 123 and a plurality of fourth color filters 124 may be alternately arranged on a cross-section that is at a different location in the second direction (Y-direction) that is perpendicular to the first direction (X-direction).

The first color filter 121 may be disposed to face the corresponding first pixel 111 in the third direction (Z-direction), the second color filter 122 may be disposed to face the corresponding second pixel 112 in the third direction (Z-direction), the third color filter 123 may be disposed to face the corresponding third pixel 113 in the third direction (Z-direction), and the fourth color filter 124 may be disposed to face the corresponding fourth pixel 114 in the third direction (Z-direction). Accordingly, the first pixel 111 and the fourth pixel 114 may sense the light of the first wavelength band that has passed through the first color filter 121 and the fourth color filter 124 respectively corresponding thereto. Also, the second pixel 112 may sense the light of the second wavelength band that has passed through the second color filter 122 corresponding thereto. The third pixel 113 may sense the light of the third wavelength that passed through the third color filter 123 corresponding thereto. For example, the first color filter 121 and the fourth color filter 124 may be green color filters transmitting the green light, the second color filter 122 may be a blue color filter transmitting the blue light, and the third color filter 123 may be a red color filter transmitting the red light.

Dashed lines shown in FIG. 5 indicate the isolations between the photosensitive cells in the first to fourth pixels 111, 112, 113, and 114. As shown in FIG. 5, the first to fourth color filters 121, 122, 123, and 124 may be arranged to face all the photosensitive cells in the first to fourth pixels 111, 112, 113, and 114 respectively corresponding thereto in the third direction (Z-direction). For example, the first color filter 121 covers and corresponds to all photosensitive cells in the first pixel 111, the second color filter 122 covers and corresponds to all photosensitive cells in the second pixel 112, the third color filter 123 covers and corresponds to all photosensitive cells in the third pixel 113, and the fourth color filter 124 covers and corresponds to all photosensitive cells in the fourth pixel 114.

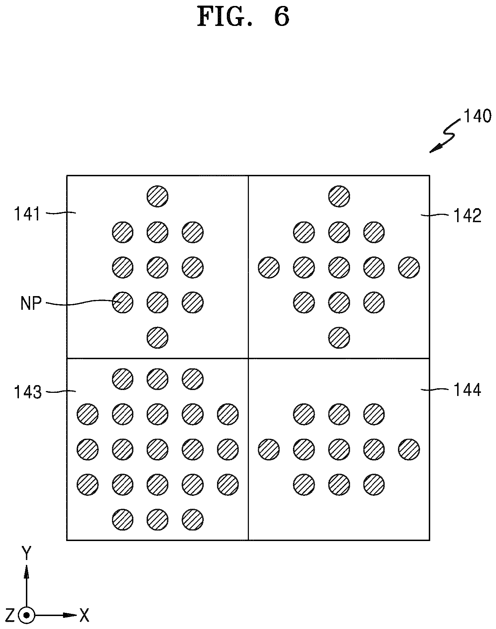

FIG. 6 is a plan view showing an example of the nano-photonic lens array 140 of FIG. 3. Referring to FIG. 6, the nano-photonic lens array 140 may include a first meta-region 141 corresponding to the first pixel 111, a second meta-region 142 corresponding to the second pixel 112, a third meta-region 143 corresponding to the third pixel 113, and a fourth meta-region 144 corresponding to the fourth pixel 114. For example, the first meta-region 141 may be disposed to face the first pixel 111 in the third direction (Z-direction), the second meta-region 142 may be disposed to face the second pixel 112 in the third direction (Z-direction), the third meta-region 143 may be disposed to face the third pixel 113 in the third direction (Z-direction), and the fourth meta-region 144 may be disposed to face the fourth pixel 114 in the third direction (Z-direction). FIG. 6 only shows one unit meta-pattern, but a plurality of first meta-regions 141 and a plurality of second meta-regions 142 may be alternately arranged in the first direction (X-direction), and a plurality of third meta-regions 143 and a plurality of fourth meta-regions 144 may be alternately arranged on a cross-section that is at a different location in the second direction (Y-direction) that is perpendicular to the first direction (X-direction).

The first to fourth meta-regions 141, 142, 143, and 144 of the nano-photonic lens array 140 may include a plurality of nano-structures NP arranged to focus incident light respectively to the first to fourth pixels 111, 112, 113, and 114. The plurality of nano-structures NP may be disposed such that a phase of light transmitted through the nano-photonic lens array 140 is changed according to a position of the plurality of nano-structures NP on the nano-photonic lens array 140. A phase profile of the transmitted light, which is implemented by the nano-photonic lens array 140, may be determined according to a width (or diameter) and a height of each of the nano-structures NP, and the arrangement period (or pitch) and arrangement type of the plurality of nano-structures NP. Also, the behavior of the light passing through the nano-photonic lens array 140 may be determined according to the phase profile of the transmitted light. For example, the plurality of nano-structures NP may be disposed to form a phase profile to focus the light transmitted through the nano-photonic lens array 140.

The nano-structures NP may each have a size that is less than a wavelength of visible light. The nano-structures NP may have a size that is less than, for example, the blue wavelength. According to one or more embodiments, a ratio of a cross-sectional width (or diameter) of the nano-structures NP with respect to an arrangement period of the plurality of nano-structures NP may be about 90% or less. Also, the ratio of a cross-sectional width (or diameter) of the nano-structures NP with respect to an arrangement period of the plurality of nano-structures NP may be about 60% to about 90%. For example, the cross-sectional width (or diameter) of the nano-structures NP may be less than 400 nm, 300 nm, or 200 nm. For example, the cross-sectional width (or diameter) of the nano-structures NP may be about 80 nm to about 200 nm. The nano-structures NP may have a height of 500 nm to 1500 nm, and the height thereof may be greater than the cross-sectional width thereof. The nano-structures NP may each have a structure including two or more layers stacked in the third direction (Z-direction).

The nano-structures NP may include a material having a relatively higher refractive index as compared with a peripheral material of the periphery of the nano-structures NP and having a relatively lower absorption ratio in the visible ray band. For example, the nano-structures NP may include c-Si, p-Si, a-Si and a Group III-V compound semiconductor (gallium phosphide (GaP), gallium nitride (GaN), gallium arsenide (GaAs), etc.), silicon carbide (SiC), titanium oxide (TiO₂), silicon nitride (SiN₃), zinc sulfide (ZnS), zinc selenide (ZnSe), silicon nitride (Si₃N₄), and/or a combination thereof. The periphery of the nano-structures NP may be filled with a dielectric material having a relatively lower refractive index as compared with the nano-structures NP and a relatively low absorbent ratio in the visible ray band. For example, the periphery of the nano-structures NP may be filled with siloxane-based spin on glass (SOG), silicon oxide (SiO₂), Si₃N₄, aluminum oxide (Al₂O₃), air, etc.

The refractive index of the nano-structures NP may be about 2.0 or greater with respect to light of about a 630 nm wavelength, and the refractive index of a peripheral material may be about 1.0 to about 2.0 or less with respect to light of about a 630 nm wavelength. Also, a difference between the refractive index of the nano-structures NP and the refractive index of the peripheral material may be about 0.5 or greater. The nano-structures NP having a difference in a refractive index between the refractive index of the peripheral material may change the phase of light that passes through the nano-structures NP. This is caused by phase delay that occurs due to the shape dimension of the sub-wavelength of the nanostructures NP, and a degree at which the phase is delayed may be determined by a detailed shape dimension and arrangement shape of the nanostructures NP.

In an example, the nano-photonic lens array 140 may focus light of the first wavelength band, in the incident light, to the first pixel 111 and the fourth pixel 114, focus light of the second wavelength band to the second pixel 112, and focus light of the third wavelength band to the third pixel 113. Then, the incident light is separated by the nano-photonic lens array 140 according to wavelengths and then focused to the first to fourth pixels 111, 112, 113, and 114. To this end, the plurality of nano-structures NP in the first to fourth meta-regions 141, 142, 143, and 144 of the nano-photonic lens array 140 may be different types of nano-structures. FIG. 6 shows that the nano-structures NP have identical diameters, but embodiments are not limited thereto. For example, diameters of the nano-structures NP may be different from one another. Also, the nano-structures NP may be arranged in various arrangements. In addition, when the incident light is sufficiently color-separated by the nano-photonic lens array 140, the color filter layer 120 may be omitted.

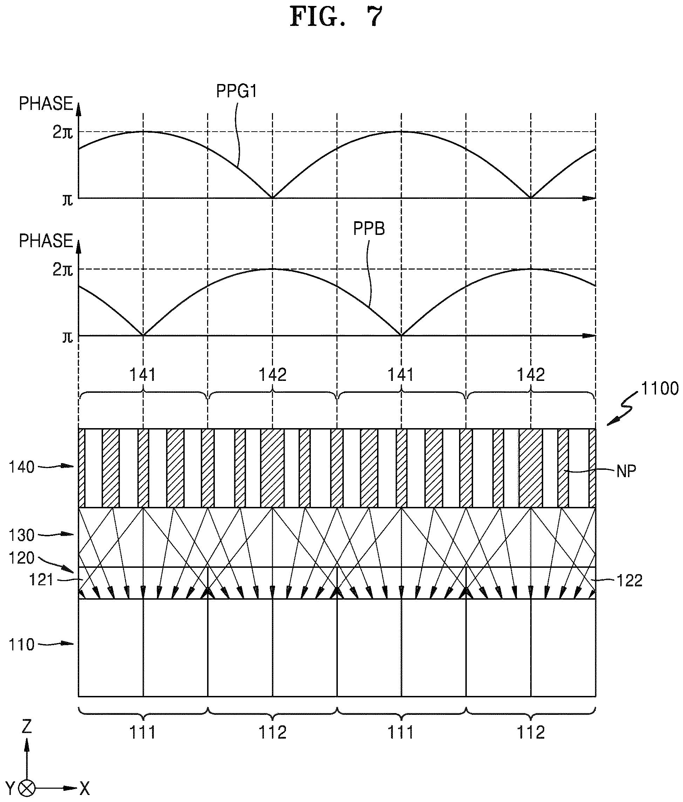

FIG. 7 is a diagram showing an example of phase profiles of green light and blue light after passing through a nano-photonic lens array at a lower surface of the nano-photonic lens array. Referring to FIG. 7, the green light after passing through the nano-photonic lens array 140 may have a first green light phase profile PPG1 that is largest at the center of the first meta-region 141 and reduces away from the center of the first meta-region 141. For example, at a position immediately after passing through the nano-photonic lens array 140, for example, on the lower surface of the nano-photonic lens array 140 or the upper surface of the planarization layer 130, the phase of the green light is largest at the center of the first meta-region 141 and may reduce in a concentric circle away from the center of the first meta-region 141. When the phase of the green light emitted from the center of the first meta-region 141 is set as 2 π, light having a phase of 0.9 π to 1.1 π may be emitted from the centers of the second and third meta-regions 142 and 143, light having a phase of 2 π may be emitted from the center of the fourth meta-region 144, and light having a phase of 1.1 π to 1.5 π may be emitted from a contact point between the first and fourth meta-regions 141 and 144. Therefore, a difference between the phase of the green light that has passed through the center of the first meta-region 141 and the phase of the green light that has passed through the centers of the second and third meta-regions 142 and 143 may be about 0.9 π to about 1.1 π.

In addition, the first green light phase profile PPG1 does not denote that the phase delay amount of the light that has passed through the center of the first meta-region 141 is the largest, but when the phase of light that has passed through the first meta-region 141 is set to 2 π and a phase delay amount of the light that has passed through another point is greater and has a phase value of 2 π or greater, the first green light phase profile PPG1 may denote a value remaining after subtracting 2n π, that is, wrapped phase profile. For example, when the phase of light that has passed through the first meta-region 141 is 2 π and the phase of light that has passed through the center of the second meta-region 142 is 3 π, the phase in the second meta-region 142 may be a remaining π after subtracting 2 π (n=1) from 3 π.

Also, the blue light that has passed through the nano-photonic lens array 140 may have a blue light phase profile PPB that is largest at the center of the second meta-region 142 and reduces away from the center of the second meta-region 142. For example, at a position immediately after passing through the nano-photonic lens array 140, the phase of the blue light may be largest at the center of the second meta-region 142 and may reduce in a concentric circle away from the center of the second meta-region 142. For example, when the phase of the blue light at the center of the second meta-region 142 is 2 π, the phase at the centers of the first and fourth meta-regions 141 and 144 may be about 0.9 π to about 1.1 π, and the phase at the center of the third meta-region 143 may be less than the phases at the centers of the first and fourth meta-regions 141 and 144, for example, about 0.5 π to about 0.9 π.

Then, in the incident light that is incident on the first meta-region 141 and the incident light that is incident on a portion of the second meta-region 142 and a portion of the third meta-region 143 around the first meta-region 141, the green light may be focused onto the first pixel 111 by the nano-photonic lens array 140. For example, according to the phase profile of the green light described above with reference to FIG. 7, the green light that has passed through a first green light condensing region that is obtained by connecting centers of two second meta-regions 142 and two third meta-regions 143 that are adjacent to the first meta-region 141 while contacting one side thereof is focused onto the first pixel 111.

Also, in the incident light incident on the second meta-region 142 and the incident light incident on a portion of the first meta-region 141, a portion of the third meta-region 143, and a portion of the fourth meta-region 144 around the second meta-region 142, the blue light is focused onto the second pixel 112 by the nano-photonic lens array 140. For example, according to the phase profile of the blue light described with reference to FIG. 7, the blue light that has passed through a blue light condensing region that is obtained by connecting the centers of four third meta-regions 143 that are adjacent to the second meta-region 142 while contacting apexes thereof onto the second pixel 112.

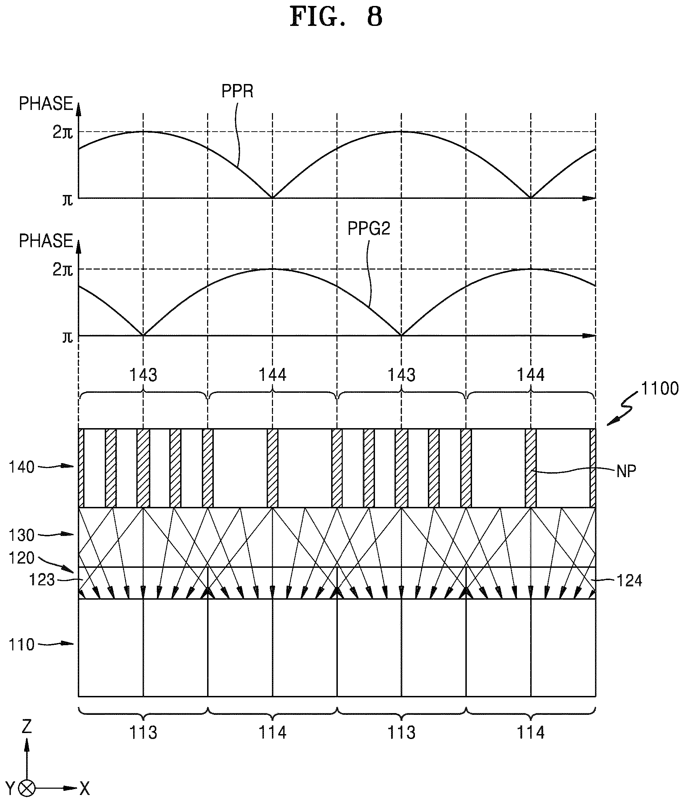

FIG. 8 is a diagram showing an example of phase profiles of red light and green light after passing through the nano-photonic lens array 140. Referring to FIG. 8, the red light after passing through the nano-photonic lens array 140 may have a red light phase profile PPR that is largest at the center of the third meta-region 143 and reduces away from the center of the third meta-region 143. For example, at a position immediately after passing through the nano-photonic lens array 140, at the lower surface of the nano-photonic lens array 140, the phase of the red light may be largest at the center of the third meta-region 143 and may reduce in a concentric circle away from the center of the third meta-region 143. When the phase of the red light at the center of the third meta-region 143 is 2 π, the phase at the centers of the first and fourth meta-regions 141 and 144 may be about 0.9 π to about 1.1 π, and the phase at the center of the second meta-region 142 may be less than that at the centers of the first and fourth meta-regions 141 and 144, for example, about 0.5 π to about 0.9 π.

Also, the green light that has passed through the nano-photonic lens array 140 may have a second green light phase profile PPG2 that is largest at the center of the fourth meta-region 144 and reduces away from the center of the fourth meta-region 144. Except that the second green light phase profile PPG2 has the largest phase at the center of the fourth meta-region 144, the descriptions about the first green light phase profile PPG1 may be also applied to the second green light phase profile PPG2.

Then, in the incident light incident on the third meta-region 143 and the incident light incident on a portion of the first meta-region 141, a portion of the second meta-region 142, and a portion of the fourth meta-region 144 around the third meta-region 143, the red light is focused onto the third pixel 113 by the nano-photonic lens array 140. For example, according to the phase profile of the red light described with reference to FIG. 8, the red light that has passed through a red light condensing region that is obtained by connecting the centers of four second meta-regions 142 that are adjacent to the third meta-region 143 while contacting apexes thereof, may be focused onto the third pixel 113.

Also, in the incident light that is incident on the fourth meta-region 144 and the incident light that is incident on a portion of the second meta-region 142 and a portion of the third meta-region 143 around the fourth meta-region 144, the green light may be focused onto the fourth pixel 114 by the nano-photonic lens array 140. For example, according to the phase profile of the green light described above with reference to FIG. 8, the green light that has passed through a second green light condensing region that is obtained by connecting centers of two second meta-regions 142 and two third meta-regions 143 that are adjacent to the fourth meta-region 144 while contacting one sides thereof, may be focused onto the fourth pixel 114.

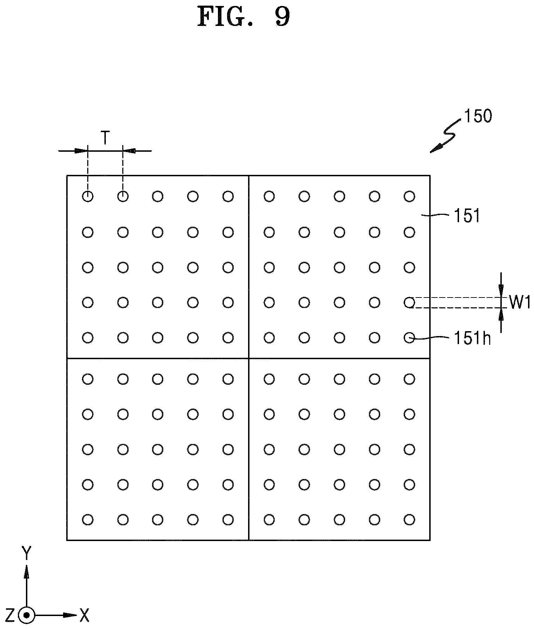

FIG. 9 is a plan view showing an example of the anti-reflection layer 150 of FIG. 3. Referring to FIG. 9, the anti-reflection layer 150 may have a structure that is patterned to have a plurality of nano-patterns that are periodically and two-dimensionally arranged. For example, the anti-reflection layer 150 may include a dielectric layer 151 that is transparent with respect to visible light, and a plurality of nano-patterns 151h that are provided through the dielectric layer 151 in the third direction (Z-direction). The dielectric layer 151 may include, for example, at least one of aluminum oxide (AIO), hafnium oxide (HfO), silicon nitride (SiN), SiO₂, aluminum oxycarbide (AlOC), aluminum oxynitride (AlON), and AlOCN, or a combination thereof. According to one or more other embodiments, the dielectric layer 151 may include another inorganic material having a refractive index of 1 to 3, in addition to the above materials. Each of the plurality of nano-patterns 151h may include a dielectric material having different refractive index from that of the dielectric layer 151. For example, each of the plurality of nano-patterns 151h may include air. In this case, each of the plurality of nano-patterns 151h may include a hole formed in the dielectric layer 151. According to one or more other embodiments, other than the air, each of the plurality of nano-patterns 151h may include a dielectric material filled in the hole of the dielectric layer 151. In FIG. 9, it is illustrated that the hole has a circular shape, but the hole is not limited to the circle and the hole may have various other shapes such as oval, square, etc. In addition, it is illustrated in FIG. 9 that the plurality of nano-patterns 151h are arranged in the form of a square lattice, but the arrangement of the plurality of nano-patterns 151h is not limited thereto. For example, the plurality of nano-patterns 151h may be arranged in various other lattice shapes such as triangles, hexagons, etc.

The anti-reflection layer 150 arranged on a light incident surface of the nano-photonic lens array 140 reduces a reflection loss of light that occurs when incident light is reflected by the nano-photonic lens array 140 under the anti-reflection layer 150. To this end, an effective refractive index (or average refractive index) of the anti-reflection layer 150 may be greater than a refractive index of air and may be less than an effective refractive index (or average refractive index) of the nano-photonic lens array 140. For example, when a refractive index section between the refractive index of air and the effective refractive index of the nano-photonic lens array 140 is divided into three sections, the effective refractive index of the anti-reflection layer 150 may be in a middle section of the three divided refractive index sections. For example, the effective refractive index of the anti-reflection layer 150 may be about 1.1 to about 1.3. The effective refractive index of the anti-reflection layer 150 may be determined by the refractive index and the volume of the dielectric layer 151 and the refractive index and the volume of the plurality of nano-patterns 151h. The effective refractive index of the nano-photonic lens array 140 may be determined by the refractive index and the volume of the nano-structures NP and a refractive index and a volume of the peripheral material. An arrangement period T of the plurality of nano-patterns 151h and a width or a diameter W1 of each of the plurality of nano-patterns 151h may be determined such that the effective refractive index of the anti-reflection layer 150 satisfies the above condition. Here, the arrangement period T of the plurality of nano-patterns 151h may be equal to a distance between centers of two nano-patterns 151h that are adjacent to each other in the first direction or the second direction.

The plurality of nano-patterns 151h may each have a size that is less than a wavelength of visible light. For example, an arrangement period T of the plurality of nano-patterns 151h may be about 300 nm or less, that is less than the wavelength of blue light. For example, the arrangement period T of the plurality of nano-patterns 151h may be about 150 nm to about 300 nm, or about 200 nm to about 280 nm. The width or the diameter W1 of each of the plurality of nano-patterns 151h may be selected such that the effective refractive index of the anti-reflection layer 150 is greater than the refractive index of the air and less than the effective refractive index of the nano-photonic lens array 140. For example, the width or the diameter W1 of each of the plurality of nano-patterns 151h may be determined such that the effective refractive index of the anti-reflection layer 150 is about 1.1 to about 1.3. To this end, a ratio (W1/T) of the width or the diameter W1 of each of the plurality of nano-patterns 151h with respect to the arrangement period T of the plurality of nano-patterns 151h according to one or more embodiments may be about 60% or more. According to one or more other embodiments, the ratio (W1/T) of the width or the diameter W1 of each of the plurality of nano-patterns 151h with respect to the arrangement period T of the plurality of nano-patterns 151h may be about 60% to about 90%. For example, the width or the diameter W1 of each of the plurality of nano-patterns 151h may be about 90 nm to about 270 nm, about 120 nm to about 250 nm, or about 150 nm to about 220 nm.

In an example, the arrangement period T of the plurality of nano-patterns 151h may be the same throughout the entire area of the anti-reflection layer 150. Also, the width or the diameter W1 of each of the plurality of nano-patterns 151h may be the same throughout the entire area of the anti-reflection layer 150, and a shape of each of the plurality of nano-patterns 151h may be the same throughout the entire area of the anti-reflection layer 150. A width of the plurality of pixels 111, 112, 113, and 114 in the sensor substrate 110 may be integer times greater than the arrangement period T of the plurality of nano-patterns 151h. Then, in the regions of the anti-reflection layer 150, which respectively face the plurality of pixels 111, 112, 113, and 114 in the third direction (Z-direction), the same number of nano-patterns 151h may be arranged.

In addition, a chief ray angle (CRA) of the light incident on the pixel array 1100 of the image sensor 1000 may vary depending on the location on the pixel array 1100. For example, when an incident angle of light perpendicularly incident on the light incident surface of the pixel array 1100 is 0°, a CRA of the light incident on the center portion of the pixel array 1100 may be 0° and increases away from the center portion of the pixel array.

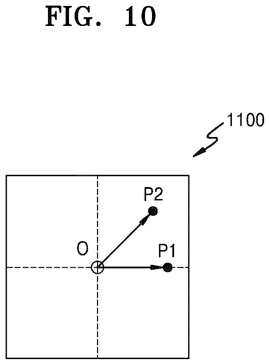

For example, FIG. 10 is a diagram showing an example of locations of a center portion and a periphery portion of the pixel array 1100 having different CRA of incident light. In FIG. 10, a point indicated by 'O' denotes a center of the pixel array 1100. The CRA of the light incident on the center of the pixel array 1100 is 0°. Therefore, a region on the pixel array 1100, where the CRA of the incident light is 0°, may be a center portion of the pixel array 1100. According to one or more other embodiments, in consideration of the convenience in the manufacturing processes, a region around the center of the pixel array 1100 may be the center portion even though the CRA of the incident light is not exactly 0°. For example, a region of the pixel array 1100, in which the CRA of the incident light is less than 10°, may be the center portion of the pixel array 1100. The periphery portion of the pixel array 1100 may be a region, in which the CRA of the incident light is greater than 0°, or may be a region, in which the CRA of the incident light is greater than 10°.

At a first position P1 and a second position P2 in the periphery portion of the pixel array 1100, the CRA of the incident light may be greater than 0° or greater than 10°. For example, the CRA may vary depending on the distance from the center O of the pixel array 1100. The CRA at two positions on the pixel array 1100 may be the same when the distance from the center O of the pixel array 1100 to the two positions is the same, even though the two positions on the pixel array 1100 are different. Also, at the first position P1 and the second position P2 that are different from each other in an azimuth direction, directions of chief rays of the incident light may be different from each other. For example, an azimuth angle at the first position P1 may be 0°, and an azimuth angle at the second position P2 may be about 45°, that is, between 0° and 90°. The azimuth angle may be an angle in a counter-clockwise direction from a reference line passing through the center O of the pixel array 1100 in parallel to the first direction (X-direction). At the first position P1, the chief ray direction of the incident light is parallel to the first direction (X-direction), and at the second position P2, the chief ray direction of the incident light is a diagonal direction between the first direction (X-direction) and the second direction (Y-direction).

As described above, in the periphery portion of the pixel array 1100, the CRA and the chief ray direction may vary depending on the position. Therefore, in order to make optical quality such as sensitivity, color-separation efficiency, and light utilization efficiency relatively uniform throughout the entire area of the pixel array 1100, positions of the first to fourth color filters 121, 122, 123, and 124 of the color filter layer 120 and the first to fourth meta-regions 141, 142, 143, and 144 of the nano-photonic lens array 140 may be adjusted considering the CRA and the chief ray direction.

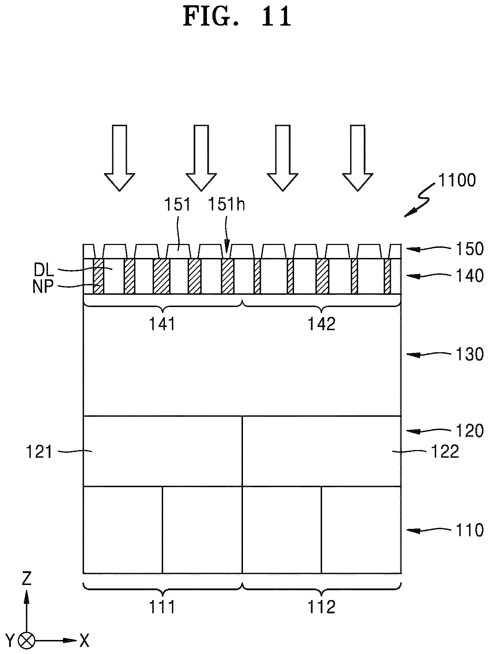

FIG. 11 is a cross-sectional view schematically showing a cross-sectional structure of the pixel array 1100 at the center portion of the pixel array 1100 according to one or more embodiments. Referring to FIG. 11, in the center portion of the pixel array 1100 on which the incident light is perpendicularly incident, boundaries of the pixel, color filter, and meta-region corresponding to one another from among a plurality of pixels, a plurality of color filters, and a plurality of meta-regions may be matched when seen in the third direction (Z-direction). For example, in the center portion of the pixel array 1100, boundaries of the first pixel 111, the first color filter 121, and the first meta-region 141 corresponding to one another may be matched when seen from the third direction (Z-direction). Also, boundaries of the second pixel 112, the second color filter 122, and the second meta-region 142 corresponding to one another may be matched when seen from the third direction (Z-direction).

Boundaries of the third pixel 113, the third color filter 123, and the third meta-region 143 corresponding to one another may be matched, and boundaries of the fourth pixel 114, the fourth color filter 124, and the fourth meta-region 144 corresponding to one another may be matched when seen from the third direction (Z-direction). In FIG. 11, `DL' denotes a peripheral material layer filled among the nano-structures NP of the nano-photonic lens array 140.

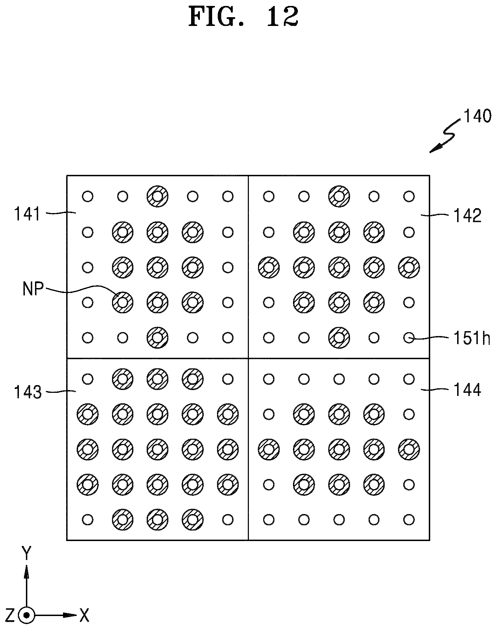

FIG. 12 shows an example of relative positions between the nano-structures NP of the nano-photonic lens array 140 and the nano-patterns 151h of the anti-reflection layer 150 in the center portion of the pixel array 1100 according to one or more embodiments. Referring to FIG. 12, in an example, the nano-structures NP of the nano-photonic lens array 140 may be arranged to face and correspond to the nano-patterns 151h of the anti-reflection layer 150 in the third direction (Z-direction). For example, in the center portion of the pixel array 1100 or the center portion of the nano-photonic lens array 140, from among the plurality of nano-structures NP of the nano-photonic lens array 140 and the plurality of nano-patterns 151h of the anti-reflection layer 150, the nano-structure and the nano-pattern corresponding to each other may be aligned to be matched with each other in the third direction (Z-direction). In this case, a pitch between the nano-structures NP of the nano-photonic lens array 140 may be equal to a pitch between the nano-patterns 151h of the anti-reflection layer 150. The pitch between the nano-structures NP denotes a distance between centers of two adjacent nano-structures NP, and the pitch between the nano-patterns 151h may denote a distance between centers of two adjacent nano-patterns 151h. The relative position between the nano-structures NP and the nano-patterns 151h shown in FIG. 12 is an example, and in another example, the relative positions between the nano-structures NP and the nano-patterns 151h may be different from that of FIG. 12, and the pitch between the nano-structures NP and the pitch between the nano-patterns 151h may be different from each other.

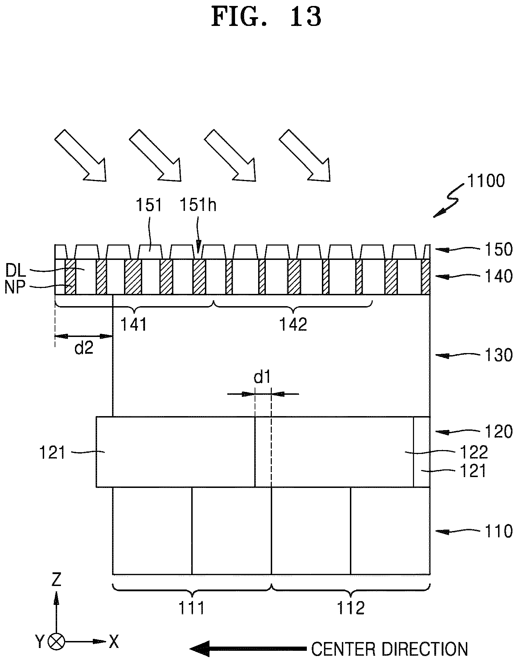

FIG. 13 is a cross-sectional view schematically showing a cross-sectional structure of the pixel array 1100 at the periphery portion of the pixel array 1100 according to one or more embodiments. Referring to FIG. 13, in the periphery portion of the pixel array 1100 on which the incident light is obliquely incident, the first to fourth color filters 121, 122, 123, and 124 of the color filter layer 120 and the first to fourth meta-regions 141, 142, 143, and 144 of the nano-photonic lens array 140 may be shifted toward the light incident direction with respect to the first to fourth pixels 111, 112, 113, and 114 corresponding thereto. For example, the first to fourth color filters 121, 122, 123, and 124 of the color filter layer 120 and the first to fourth meta-regions 141, 142, 143, and 144 of the nano-photonic lens array 140 may be shifted toward the center portion of the pixel array 1100 with respect to the first to fourth pixels 111, 112, 113, and 114 corresponding thereto. For example, the first to fourth color filters 121, 122, 123, and 124 of the color filter layer 120 may be shifted by a first distance d1 toward the center portion of the pixel array 1100 with respect to the first to fourth pixels 111, 112, 113, and 114 corresponding thereto, and the first to fourth meta-regions 141, 142, 143, and 144 of the nano-photonic lens array 140 may be shifted by a second distance d2 toward the center portion of the pixel array 1100 with respect to the first to fourth pixels 111, 112, 113, and 114 corresponding thereto. The second distance d2, that is, the shifted distance of the first to fourth meta-regions 141, 142, 143, and 144, may be greater than the first distance d1, that is, the shifted distance of the first to fourth color filters 121, 122, 123, and 124. Therefore, in the periphery portion of the pixel array 1100, boundaries of the pixel, color filter, and meta-region corresponding to one another may not be matched in the third direction (Z-direction). The shifted distances of the first to fourth color filters 121, 122, 123, and 124 and the first to fourth meta-regions 141, 142, 143, and 144 may increase away from the center of the pixel array 1100.

The nano-patterns 151h of the anti-reflection layer 150 may be also shifted toward the incident direction of the light with respect to the first to fourth pixels 111, 112, 113, and 114. For example, the plurality of nano-patterns 151h of the anti-reflection layer 150 may be shifted toward the center portion of the pixel array 1100 with respect to the first to fourth pixels 111, 112, 113, and 114. The nano-patterns 151h of the anti-reflection layer 150 may be shifted by near the same distance as those of the first to fourth meta-regions 141, 142, 143, and 144. For example, the nano-patterns 151h may be shifted toward the center portion of the pixel array 1100 by the second distance d2 or nearly the same distance as the second distance d2. When the nano-patterns 151h of the anti-reflection layer 150 are not shifted, the relative positions between the nano-patterns 151h of the anti-reflection layer 150 and the nano-structures NP of the nano-photonic lens array 140 may vary depending on the position on the pixel array 1100.

Near-field interference may occur between the nano-patterns 151h of the anti-reflection layer 150 and the nano-structures NP of the nano-photonic lens array 140, and interference degree may vary depending on the relative positions between the nano-patterns 151h of the anti-reflection layer 150 and the nano-structures NP of the nano-photonic lens array 140. Therefore, when the relative positions between the nano-patterns 151h of the anti-reflection layer 150 and the nano-structures NP of the nano-photonic lens array 140 vary depending on the position on the pixel array 1100, the interference degree between the nano-patterns 151h and the nano-structures NP vary depending on the position of the pixel array 1100, and accordingly, the optical characteristics of the image sensor 1000 may vary depending on the position on the pixel array 1100. Therefore, the relative positions between the nano-patterns 151h and the nano-structures NP may be maintained constantly within a certain range in the entire area of the pixel array 1100, the entire area of the nano-photonic lens array 140, or the entire area of the anti-reflection layer 150, such that the interference between the nano-patterns 151h and the nano-structures NP may be relatively uniform in the entire area of the pixel array 1100, the entire area of the nano-photonic lens array 140, or the entire area of the anti-reflection layer 150.

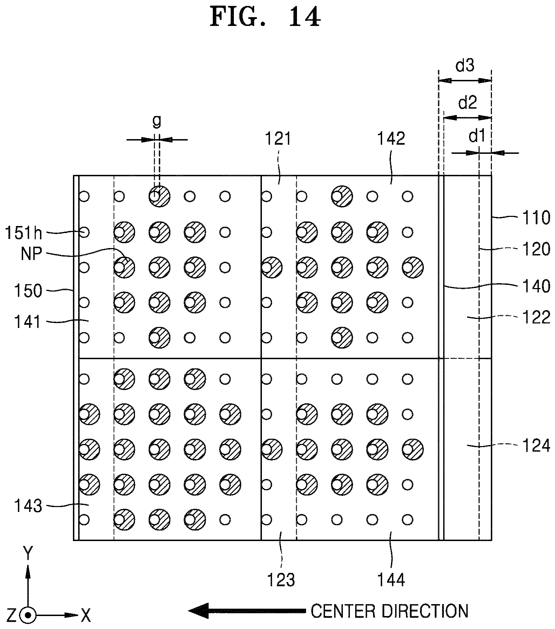

FIG. 14 shows an example of relative positions between the nano-structures NP of the nano-photonic lens array 140 and the nano-patterns 151h of the anti-reflection layer 150 at the first position P1 in the periphery portion of the pixel array 1100 according to one or more embodiments. Referring to FIG. 14, the first to fourth color filters 121, 122, 123, and 124 of the color filter layer 120 may be shifted toward the center portion of the pixel array 1100 by the first distance d1 in the first direction. The first to fourth meta-regions 141, 142, 143, and 144 of the nano-photonic lens array 140 may be shifted toward the center portion of the pixel array 1100 by the second distance d2 that is greater than the first distance d1 in the first direction. Also, the nano-patterns 151h of the anti-reflection layer 150 may be shifted toward the center portion of the pixel array 1100 by a third distance d3 in the first direction.

FIG. 14 shows an example in which the third distance d3 that is the shifted distance of the nano-patterns 151h is greater than the second distance d2 that is the shifted distance of the first to fourth meta-regions 141, 142, 143, and 144 of the nano-photonic lens array 140, but embodiments are not limited thereto. As described above, the relative positions between the nano-patterns 151h and the nano-structures NP may be uniform in the entire area of the pixel array 1100, such that the interference between the nano-patterns 151h and the nano-structures NP may be uniform in the entire area of the pixel array 1100. To this end, the third distance d3 and the second distance d2 may be equal to each other. Also, considering an alignment error during the manufacturing processes, the third distance d3 and the second distance d2 do not need to be exactly the same as each other, and the third distance d3 may be slightly greater or less than the second distance d2. For example, it is illustrated in FIG. 14 that the third distance d3 is greater than the second distance d2, but the third distance d3 may be smaller than the second distance d2. For example, there may be a deviation within a certain range between the third distance d3 and the second distance d2 in the entire area of the pixel array 1100. For example, at the first position P1 where the azimuth angle is 0°, a deviation between the third distance d3 and the second distance d2 in the first direction (X-direction) may be within a range ±1/4 of the arrangement period T of the nano-patterns 151h. When it is expressed in a mathematic formula, a condition d2 - T/4 ≤ d3 ≤ d2 + T/4 in the first direction (X-direction) may be satisfied at the first position P1 where the azimuth angle is 0° on the pixel array 1100.

When the second distance d2 and the third distance d3 are equal to each other in the first direction (X-direction), in the entire area of the pixel array 1100 or the nano-photonic lens array 140, from among the plurality of nano-structures NP of the nano-photonic lens array 140 and the plurality of nano-patterns 151h of the anti-reflection layer 150, the nano-structure and the nano-pattern corresponding to each other may be aligned to be matched with each other in the first direction (X-direction). For example, in the entire area of the pixel array 1100 or the nano-photonic lens array 140, distances between the plurality of nano-structures NP and the plurality of nano-patterns 151h corresponding to each other may be 0 (zero) in the first direction (X-direction). Here, a distance g between one nano-structure NP and the nano-pattern 151h corresponding to or closest to the nano-structure NP may be a gap between a cross-sectional center of the nano-structure NP and a cross-sectional center of the nano-pattern 151h on a plane (XY plane) perpendicular to the third direction (Z-direction) or a surface that is parallel to the upper or lower surface of the nano-photonic lens array 140.

When the second distance d2 and the third distance d3 have the deviation within the above range, the distances between the plurality of nano-structures NP and the plurality of nano-patterns 151h corresponding to each other may have a deviation within a certain range throughout the entire area of the pixel array 1100 or the nano-photonic lens array 140. For example, when, from among the plurality of nano-structures NP, a nano-structure arranged on one position on the nano-photonic lens array 140 is referred to as a first nano-structure, and when, from among the plurality of nano-patterns 151h, a nano-pattern corresponding to or closest to the first nano-structure is referred to as a first nano-pattern, a distance between the first nano-structure and the first nano-pattern in the first direction (X-direction) may be set as g1. Also, when, from among the plurality of nano-structures NP, a nano-structure different from the first nano-structure is referred to as a second nano-structure, and when, from among the plurality of nano-patterns 151h, a nano-pattern corresponding to or closest to the second nano-structure is referred to as a second nano-pattern, a distance between the second nano-structure and the second nano-pattern in the first direction (X-direction) may be set as g2. Here, since g1 and g2 indicate distances, g1 and g2 may always have a value equal to or greater than 0.

The plurality of nano-structures NP may be included in repeating meta-regions. For example, corresponding to the unit pixel patterns shown in FIG. 2A, the unit meta-patterns including the first meta-region 141, the second meta-region 142, the third meta-region 143 and the fourth meta-region 144 shown in FIG. 6 may be repeatedly arranged. Accordingly, the nano-structures provided in the first meta-region 141, the second meta-region 142, the third meta-region 143 and the fourth meta-region 144 may be also repeated and the first nano-structure and the second nano-structure may have a repeating nanostructure relationship with each other. For example, two nano-structures located at a relatively same position within two meta-regions of the same type in different regions in the image sensor 1000, among the first meta-region 141, the second meta-region 142, the third meta-region 143 and the fourth meta-region 144, may be selected as the first nano-structure and the second nano-structure. Hereinafter, the relationship between two nano-structures located at a relatively same position within two meta-regions of the same type is defined as a repeating nano-structure relationship. For example, a nano-structure included in the second meta-region 142 corresponding to the second pixel 112 (eg, blue pixel) in the unit pixel pattern located at the center portion of the image sensor 1000 may be the first nano-structure and a nano-structure included in the second meta-region 142 corresponding to the second pixel 112 (e.g., blue pixel) in the unit pixel pattern located at the periphery portion of the image sensor 1000 may be the second nano-structure.

Then, an absolute value of a difference between g1 and g2, that is, |g1 - g2| = Δg, may satisfy a condition Δg ≤ T/4. The deviation Δg may be applied to entire regions on the pixel array 1100 or the nano-photonic lens array 140. For example, the condition Δg ≤ T/4 may be satisfied with respect to any of the first nano-structure and the second nano-structure selected from arbitrary different positions of the pixel array 1100 or the nano- photonic lens array 140. For example, the absolute value Δg of the difference between the distance g1 between the first nano-structure and the first nano-pattern closest to the first nano-structure within any one meta-region, among the first meta-region 141, the second meta-region 142, the third meta-region 143 and the fourth meta-region 144 at a left edge portion of the image sensor 1000, the pixel array 1100, or the nano-photonic lens array 140, and the distance g2 between the second nano-structure and the second nano-pattern closest to the second nano-structure within the same type of meta-region as the meta-region to which the first nano-structure belongs, among the first meta-region 141, the second meta-region 142, the third meta-region 143 and the fourth meta-region 144 at a right edge portion of the image sensor 1000, the pixel array 1100, or the nano-photonic lens array 140, may have a value of T/4 or less.

When the first nano-structure is arranged in the center portion of the nano-photonic lens array 140, the first nano-structure and the first nano-pattern may be aligned to be matched with each other as shown in FIG. 12 (that is, g1=0). Also, when the second nano-structure is arranged in the periphery portion of the nano-photonic lens array 140, the second nano-structure may be aligned to be matched with the second nano-pattern or, as shown in FIG. 14, may be aligned out of line with each other. When the second nano-structure and the second nano-pattern are aligned out of line with each other, the distance g2 between the second nano-structure and the second nano-pattern in the first direction (X-direction) may be up to T/4 (that is, 0 ≤ g2 ≤ T/4).

When the second distance d2 and the third distance d3 are equal to each other in the entire area of the pixel array 1100 or the nano-photonic lens array 140, there may not be a deviation in the distances between the plurality of nano-structures NP and the plurality of nano-patterns 151h corresponding to each other. In this case, in the entire area of the pixel array 1100 or the nano-photonic lens array 140, Δg may be 0. In the periphery portion of the nano-photonic lens array 140, the second distance d2 and the third distance d3 may have a deviation within the above range. In this case, when the first nano-structure is arranged in the center portion of the nano-photonic lens array 140 and the second nano-structure is arranged in the periphery portion of the nano-photonic lens array 140, g1 and g2 may have different values within the above range (that is, 0 ≤ g1 ≤ T/4, 0 ≤ g2 ≤ T/4).

In FIG. 14, the first position P1 in the periphery portion of the pixel array 1100, where the azimuth angle is 0°, is described, but the description may be also applied to the position in the periphery portion of the pixel array 1100, where the azimuth angle is 90°, and the directions only differ. For example, at one point in the periphery portion of the pixel array 1100 where the azimuth angle is 90°, the deviation between the third distance d3 and the second distance d2 may be determined based on the second direction (Y-direction). For example, at one point in the pixel array 1100 where the azimuth angle is 90°, the deviation between the third distance d3 and the second distance d2 in the second direction (Y-direction) may be within ±1/4 of the arrangement period T of the nano-patterns 151h. For example, a condition d2 - T/4 ≤ d3 ≤ d2 + T/4 in the second direction may be satisfied at one point in the periphery portion of the pixel array 1100 where the azimuth angle is 90°. Likewise, a condition Δg≤T/4 in the second direction (Y-direction) may be satisfied at points in the pixel array 1100 where the azimuth angle is 90°.

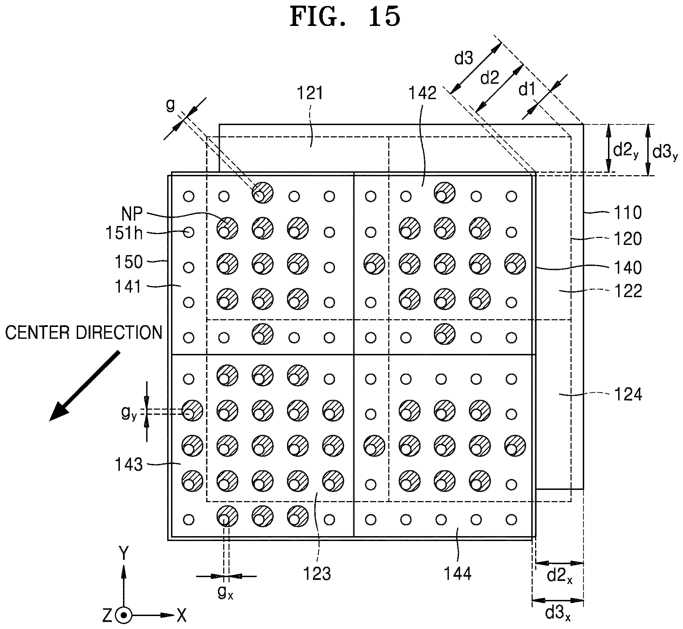

FIG. 15 shows an example of relative positions between the nano-structures NP of the nano-photonic lens array 140 and the nano-patterns 151h of the anti-reflection layer 150 at the second position P2 in the periphery portion of the pixel array 1100 according to one or more embodiments. Referring to FIG. 15, at the second position P2 in the periphery portion of the pixel array 1100, the first to fourth color filters 121, 122, 123, and 124 of the color filter layer 120 are shifted by the first distance d1 toward the center portion of the pixel array 1100 in the diagonal direction, and the first to fourth meta-regions 141, 142, 143, and 144 of the nano-photonic lens array 140 may be shifted by the second distance d2 toward the center portion of the pixel array 1100 in the diagonal direction. Also, the nano-patterns 151h of the anti-reflection layer 150 may be shifted by the third distance d3 toward the center portion of the pixel array 1100 in the diagonal direction.

Except that the shifted direction at the second position P2 that is different from the first position P1 in the periphery portion of the pixel array 1100 is the diagonal direction, the descriptions about the shifted distance provided above with reference to FIG. 14 may be equally applied to the second position P2. For example, at the second position P2 where the azimuth angle is greater than 0° and less than 90°, a deviation between the shifted distance of the nano-patterns 151h and the shifted distance of the first to fourth meta-regions 141, 142, 143, and 144 of the nano-photonic lens array 140 and the deviation Δg with respect to the relative positions between the nano-patterns 151h and the nano-structures NP may be determined as the diagonal direction toward the center portion of the pixel array 1100. For example, a condition d2 - T/4 ≤ d3 ≤ d2+T/4 may be satisfied in the diagonal direction toward the center portion of the pixel array 1100. Also, the condition Δg≤T/4 may be satisfied in the diagonal direction toward the center portion of the pixel array 1100.

When the first to fourth meta-regions 141, 142, 143, and 144 of the nano-photonic lens array 140 and the nano-patterns 151h of the anti-reflection layer 150 are shifted toward the center portion of the pixel array 1100 in the diagonal direction, aspects of the first direction (X-direction) and the second direction (Y-direction) may be considered. For example, the first to fourth meta-regions 141, 142, 143, and 144 of the nano-photonic lens array 140 may be shifted by a second x distance d2ₓ in the first direction and by a second y distance d2_{y} in the second direction. The nano-patterns 151h of the anti-reflection layer 150 may be shifted by a third x distance d3ₓ in the first direction and by a third y distance d3_{y} in the second direction. In this case, the second distance d2 in the diagonal direction may be a square root of a sum of a square of the second x distance d2ₓ and a square of the second y distance d2_{y}, and the third distance d3 in the diagonal direction may be a square root of a sum of a square of the third x distance d3ₓ and a square of the third y distance d3_{y}. The second x distance d2ₓ and the third x distance d3ₓ in the first direction and the second y distance d2_{y} and the third y distance d3_{y} in the second direction may be within a range satisfying the condition d2 - T/4 ≤ d3 ≤ d2+T/4 in the diagonal direction.

Also, the distance g in the diagonal direction between one nano-structure NP and the nano-pattern 151h corresponding to or closest to the nano-structure may be a square root of a sum of a square of a distance gₓ in the first direction and a square of a distance g_{y} in the second direction. A deviation Δgₓ with respect to relative positions between the nano-pattern 151h and the nano-structure NP in the first direction and a deviation Δg_{y} with respect to relative positions between the nano-pattern 151h and the nano-structure NP in the second direction may be within a range satisfying the condition Δg ≤ T/4 in the diagonal direction.

In the entire area of the pixel array 1100, the deviation between the third distance d3 and the second distance d2 in the direction toward the center portion of the pixel array 1100 may be within a range ±1/4 of the arrangement period T of the nano-patterns 151h in the direction in which the first to fourth meta-regions 141, 142, 143, and 144 of the nano-photonic lens array 140 and the nano-patterns 151h of the anti-reflection layer 150 are shifted. According to one or more other embodiments, in the entire area of the pixel array 1100, a condition d2 - T/4 ≤ d3 ≤ d2 + T/4 may be satisfied in the direction in which the first to fourth meta-regions 141, 142, 143, and 144 of the nano-photonic lens array 140 and the nano-patterns 151h of the anti-reflection layer 150 are shifted or in the direction toward the center portion of the pixel array 1100. Also, the condition Δg ≤ T/4 in the direction in which the first to fourth meta-regions 141, 142, 143, and 144 of the nano-photonic lens array 140 and the nano-patterns 151h of the anti-reflection layer 150 are shifted or in the direction toward the center of the pixel array 1100 may be satisfied in the entire area of the pixel array 1100.

Based on the center and periphery portions of the pixel array 1100, the positions of the first to fourth color filters 121, 122, 123, and 124 of the color filter layer 120, the positions of the first to fourth meta-regions 141, 142, 143, and 144 of the nano-photonic lens array 140, and the positions of the nano-patterns 151h of the anti-reflection layer 150 are described. The center portion of the pixel array 1100 may match the center portion of the color filter layer 120, the center portion of the nano-photonic lens array 140, and the center portion of the anti-reflection layer 150 in the third direction (Z-direction), and thus, the same description may be also applied to the center portion and periphery portion of the color filter layer 120, the center portion and periphery portion of the nano-photonic lens array 140, and the center portion and periphery portion of the anti-reflection layer 150. For example, the above descriptions about the positions of the first to fourth color filters 121, 122, 123, and 124 of the color filter layer 120, the positions of the first to fourth meta-regions 141, 142, 143, and 144 of the nano-photonic lens array 140, and the nano-patterns 151h of the anti-reflection layer 150 in the center portion of the pixel array 1100 may be equally applied to the center portion of the color filter layer 120, the center portion of the nano-photonic lens array 140, and the center portion of the anti-reflection layer 150. Also, the above descriptions about the positions of the first to fourth color filters 121, 122, 123, and 124 of the color filter layer 120, the positions of the first to fourth meta-regions 141, 142, 143, and 144 of the nano-photonic lens array 140, and the nano-patterns 151h of the anti-reflection layer 150 in the periphery portion of the pixel array 1100 may be equally applied to the periphery portion of the color filter layer 120, the periphery portion of the nano-photonic lens array 140, and the periphery portion of the anti-reflection layer 150. Likewise, the descriptions about the relative positions between the nano-structures NP of the nano-photonic lens array 140 and the nano-patterns 151h of the anti-reflection layer 150 in the entire area of the pixel array 1100 may be equally applied to the entire area of the nano-photonic lens array 140 and the entire area of the anti-reflection layer 150.

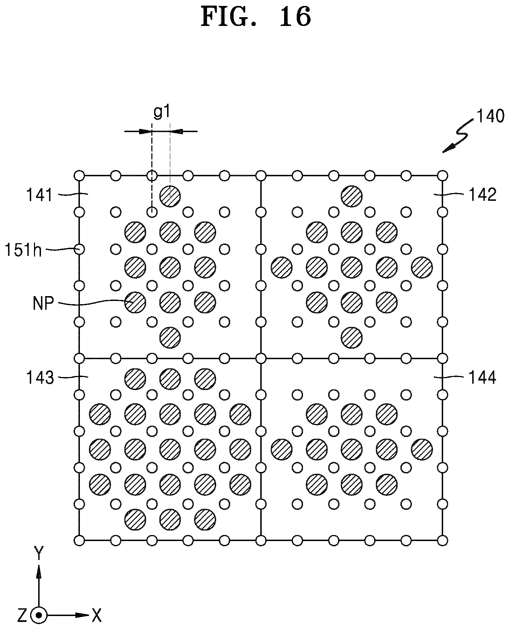

FIG. 16 shows an example of relative positions between the nano-structures NP of the nano-photonic lens array 140 and the nano-patterns 151h of the anti-reflection layer 150 in the center portion of the pixel array 1100 according to one or more other embodiments. FIGS. 12 to 15 show the examples in which the nano-structures NP of the nano-photonic lens array 140 and the nano-patterns 151h of the anti-reflection layer 150 face each other in the third direction (Z-direction). However, the relative positions between the nano-structures NP of the nano-photonic lens array 140 and the nano-patterns 151h of the anti-reflection layer 150 are not limited to the above examples. Referring to FIG. 16, when seen in the third direction (Z-direction), the plurality of nano-patterns 151h may be arranged among the plurality of nano-structures NP. For example, when seen in the third direction (Z-direction), the plurality of nano-structures NP may be arranged among the plurality of nano-patterns 151h. For example, when seen in the third direction (Z-direction), the plurality of nano-patterns 151h and the plurality of nano-structures NP may be alternately arranged such that the plurality of nano-patterns 151h and the plurality of nano-structures NP do not overlap each other. For example, each of the plurality of nano-patterns 151h arranged in the center portion of the pixel array 1100 or the center portion of the nano-photonic lens array 140 may be located at the same distance from four nano-structures NP adjacent thereto. In this case, in the center portion of the pixel array 1100 or the center portion of the nano-photonic lens array 140, a distance g1 between each of the plurality of nano-patterns 151h and the nano-structure NP closest to the nano-pattern in the first direction or the second direction may be g1=T/2.

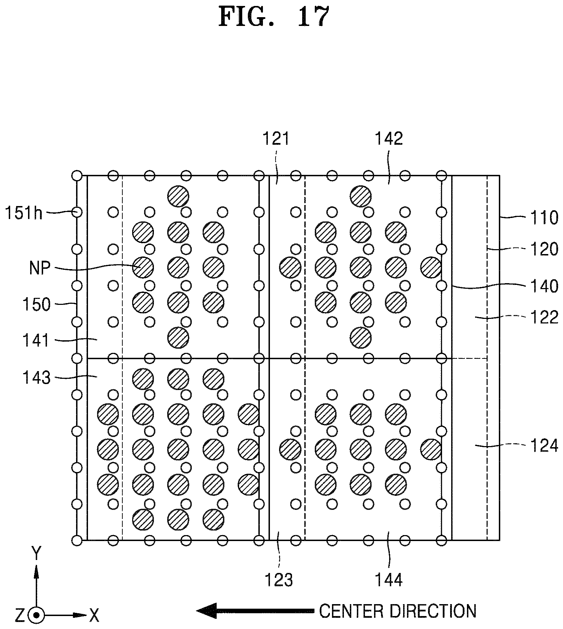

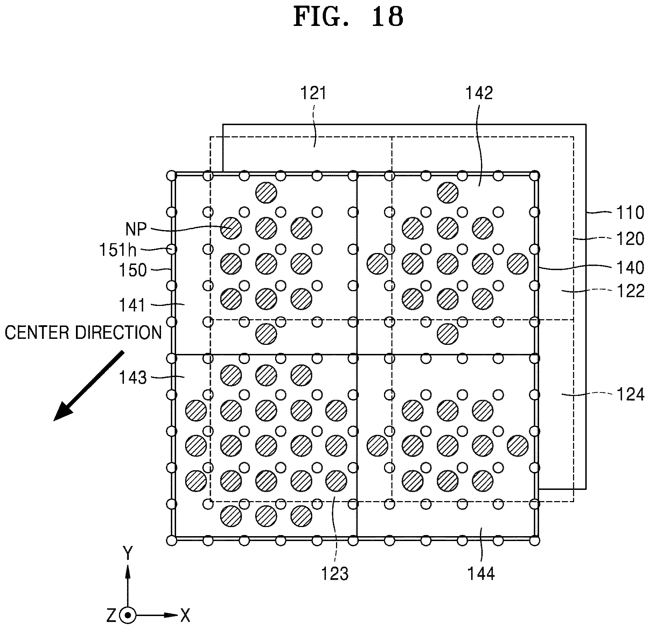

FIG. 17 shows an example of the relative positions between the nano-structures NP of the nano-photonic lens array 140 and the nano-patterns 151h of the anti-reflection layer 150 at the first position P1 in the periphery portion of the pixel array 1100 according to one or more other embodiments, and FIG. 18 shows an example of the relative positions between the nano-structures NP of the nano-photonic lens array 140 and the nano-patterns 151h of the anti-reflection layer 150 at the second position P2 in the periphery portion of the pixel array 1100 according to one or more other embodiments. Referring to FIGS. 17 and 18, at the first position P1 and the second position P2 in the periphery portion of the pixel array 1100, the first to fourth color filters 121, 122, 123, and 124 of the color filter layer 120, the first to fourth meta-regions 141, 142, 143, and 144 of the nano-photonic lens array 140, and the nano-patterns 151h of the anti-reflection layer 150 may be shifted toward the center portion of the pixel array 1100. As described above with reference to FIGS. 14 and 15, the shifted distance of the nano-patterns 151h of the anti-reflection layer 150 may be the same as the shifted distance of the first to fourth meta-regions 141, 142, 143, and 144 of the nano-photonic lens array 140 in the shifted direction, or may be different within a range of ±1/4 of the arrangement period T of the nano-patterns 151h in the shifted direction.

Based on the relative positions between the nano-patterns 151h and the nano-structures NP being maintained to be nearly the same within a certain range in the entire area including the center portion and the periphery portion of the pixel array 1100, the arrangement type of the plurality of nano-patterns 151h and the arrangement type of the plurality of nano-structures NP may be independently configured from each other. For example, regardless of the arrangement type of the plurality of nano-patterns 151h and the arrangement type of the plurality of nano-structures NP, the deviation Δg of the relative positions between the nano-patterns 151h and the nano-structures NP in the periphery portion of the pixel array 1100 with respect to the relative positions between the nano-patterns 151h and the nano-structures NP in the center portion of the pixel array 1100 may satisfy the condition Δg ≤ T/4.

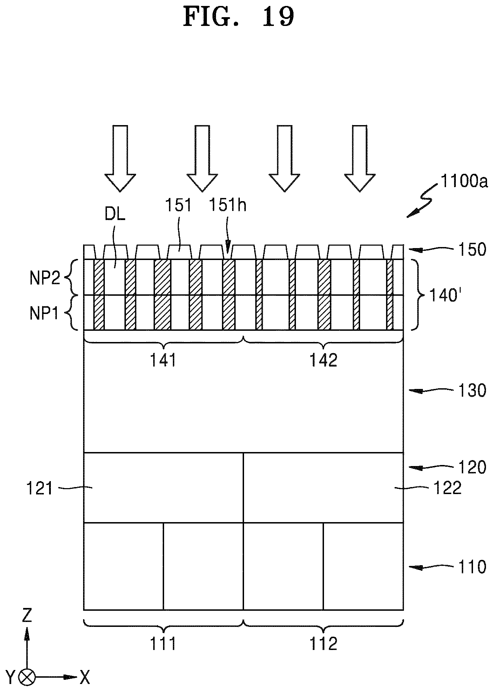

FIG. 19 is a cross-sectional view schematically showing a cross-sectional structure of a pixel array in the center portion of a pixel array according to one or more other embodiments. Referring to FIG. 19, a pixel array 1100a according to one or more other embodiments may include the sensor substrate 110, the color filter layer 120, the planarization layer 130, a nano-photonic lens array 140', and the anti-reflection layer 150. The nano-photonic lens array 140' may include nano-structures in a two-layered structure. For example, each of the plurality of nano-structure of the nano-photonic lens array 140' may include a first nano-structure layer NP1 and a second nano-structure layer NP2 provided on the first nano-structure layer NP1. The plurality of first nano-structures layers NP1 and the plurality of second nano-structure layers NP2 may have the same arrangements, but may have different arrangements in consideration of a color-separation efficiency and sensitivity according to the CRA. The other structures in the pixel array 1100a shown in FIG. 19 may be the same as those of the pixel array 1100 described above.

According to one or more embodiments, when the nano-photonic lens array 140' includes two or more layers of nano-structures, based on the nano-structures disposed immediately under the nano-patterns 151h of the anti-reflection layer 150, the relative positions between the nano-patterns 151h and the nano-structures may be constantly maintained throughout the entire area of the pixel array 1100a. For example, when the nano-structures are arranged in the two-layered structure, the relative positions between the nano-patterns 151h and the second nano-structure layer NP2 may be constantly maintained within a certain range throughout the entire area of the pixel array 1100a. Also, when the nano-structures are arranged in a three-layered structure including third nano-structure layer disposed on the second nano-structure layer NP2, the relative positions between the nano-structures NP and the third nano-structure layer may be constantly maintained within a certain range throughout the entire area of the pixel array 1100a.

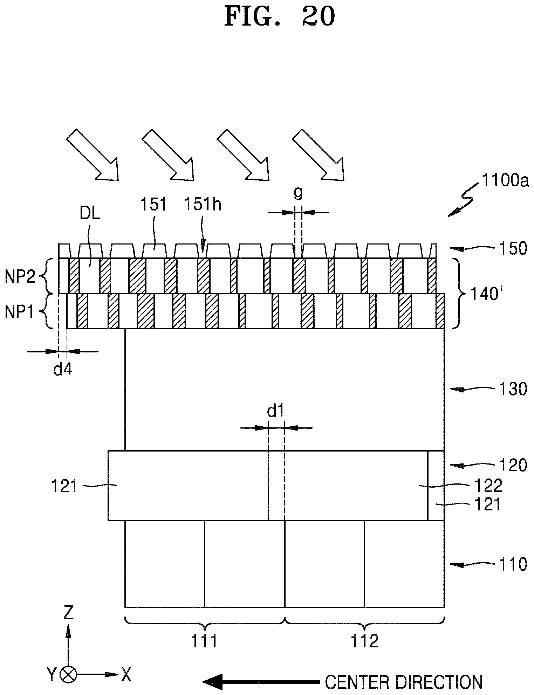

FIG. 20 is a cross-sectional view schematically showing a cross-sectional structure of the pixel array 1100a in the periphery portion of the pixel array 1100a according to one or more other embodiments. Referring to FIG. 20, the shifted distance of the first to fourth color filters 121, 122, 123, and 124 of the color filter layer 120 is the same as the above description. The shifted distance of the first nano-structure layer NP1 may be the same as the shifted distance of the first to fourth meta-regions 141, 142, 143, and 144 described above. The second nano-structure layer NP2 may be further shifted by a fourth distance d4 toward the center portion of the pixel array 1100a, as compared with the first nano-structure layer NP1. The deviation Δg of the relative positions between the nano-patterns 151h and the second nano-structure layer NP2 in the periphery portion of the pixel array 1100a with respect to the relative positions between the nano-patterns 151h and the second nano-structure layer NP2 in the center portion of the pixel array 1100a may be within a range ±1/4 of the arrangement period T of the nano-patterns 151h. For example, the deviation Δg of the relative positions between the nano-patterns 151h and the second nano-structure layer NP2 in the periphery portion of the pixel array 1100a with respect to the relative positions between the nano-patterns 151h and the second nano-structure layer NP2 in the center portion of the pixel array 1100a may satisfy the condition Δg ≤ T/4.

The deviation Δg may satisfy the condition Δg ≤ T/4 in the entire area of the pixel array 1100a or the entire area of the nano-photonic lens array 140. For example, when, from among the plurality of nano-structures NP, the nano-structure arranged at one position in the nano-photonic lens array 140 is referred to as a first nano-structure, and when, from among the plurality of nano-patterns 151h, the nano-pattern corresponding to or closest to the first nano-structure is referred to the first nano-pattern, a distance between the second nano-structure layer NP2 of the first nano-structure and the first nano-pattern may be set as g1. Also, when, from among the plurality of nano-structures NP, the nano-structure different from the first nano-structure is referred to as a second nano-structure, and when, from among the plurality of nano-patterns 151h, a nano-pattern corresponding to or closest to the second nano-structure is referred to as a second nano-pattern, a distance between the second nano-structure layer NP2 of the second nano-structure and the second nano-pattern may be set as g2. Then, an absolute value of a difference between g1 and g2, that is, |g1 - g2| = Δg, may satisfy the condition Δg ≤ T/4 in the entire area of the pixel array 1100a or the entire area of the nano-photonic lens array 140.

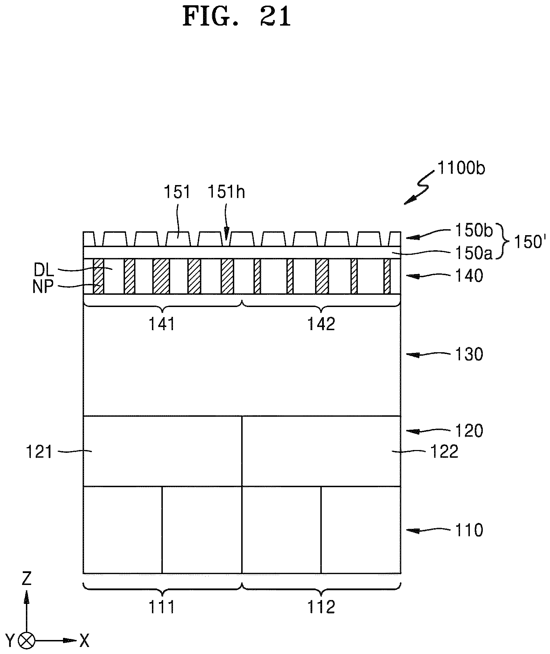

FIG. 21 is a cross-sectional view schematically showing a cross-sectional structure of a pixel array 1100b in the center portion of the pixel array according to one or more other embodiments. Referring to FIG. 21, a pixel array 1100b according to one or more other embodiments may include the sensor substrate 110, the color filter layer 120, the planarization layer 130, the nano-photonic lens array 140, and an anti-reflection layer 150'. In the pixel array 1100b of FIG. 21, the other structures than the anti-reflection layer 150' may be the same as those of the pixel array 1100 described above.

The anti-reflection layer 150' may include a first anti-reflection layer 150a and a second anti-reflection layer 150b provided on the first anti-reflection layer 150a. The first anti-reflection layer 150a may have a thin film structure that is continuously provided to a constant thickness in the third direction (Z direction) on the upper surface of the nano-photonic lens array 140. For example, the first anti-reflection layer 150a may have a thin film structure that is not patterned. The second anti-reflection layer 150b may include the dielectric layer 151 and the plurality of nano-patterns 151h that are patterned, similar to the anti-reflection layer 150 described above.

The first anti-reflection layer 150a may include a transparent dielectric material having a higher refractive index as compared with the second anti-reflection layer 150b. For example, the first anti-reflection layer 150a includes at least one dielectric material of AlO, SiN, and HfO, and the dielectric layer 151 of the second anti-reflection layer 150b may include SiO₂ or AlON. The first anti-reflection layer 150a may have a thickness of about 5 nm to about 50 nm. According to one or more embodiments, an effective refractive index of the nano-photonic lens array 140, an effective refractive index of the first anti-reflection layer 150a, and an effective refractive index of the second anti-reflection layer 150b may be sequentially reduced. For example, from among the nano-photonic lens array 140, the first anti-reflection layer 150a, and the second anti-reflection layer 150b, the effective refractive index of the nano-photonic lens array 140 is largest and the effective refractive index of the second anti-reflection layer 150b may be smallest. Also, the first anti-reflection layer 150a may act as an etch stop layer protecting the nano-photonic lens array 140 so as not to be etched, during an etching process for forming the plurality of nano-patterns 151h of the second anti-reflection layer 150b.

In the anti-reflection layer 150' of a two-layered structure including the first anti-reflection layer 150a and the second anti-reflection layer 150b, relative positions between the nano-patterns 151h of the second anti-reflection layer 150b and the nano-structures NP of the nano-photonic lens array 140 may be constantly maintained within a certain range throughout the entire area of the pixel array 1100b.

In the image sensor 1000 according to one or more embodiments, the nano-photonic lens array 140 may color-separate the incident light without absorbing or reflecting the incident light and then focus the color-separated light onto each of the plurality of pixels, and thus, the light utilization efficiency may be improved and the degradation in resolution may be reduced. Also, by reducing the reflection loss of light due to the anti-reflection layers 150 and 150', the light utilization efficiency of the image sensor 1000 may be further improved, and the optical characteristics may be consistently maintained throughout the entire area of the image sensor 1000 or the entire area of the pixel array 1100, 1100a, or 1100b. Therefore, a size of one pixel or sizes of independent photosensitive cells in the pixel of the image sensor 1000 may be reduced, and thus, the image sensor 1000 having higher resolution may be provided. The image sensor 1000 according to one or more embodiments may form a camera module along with a module lens of various functions and may be utilized in various electronic devices.

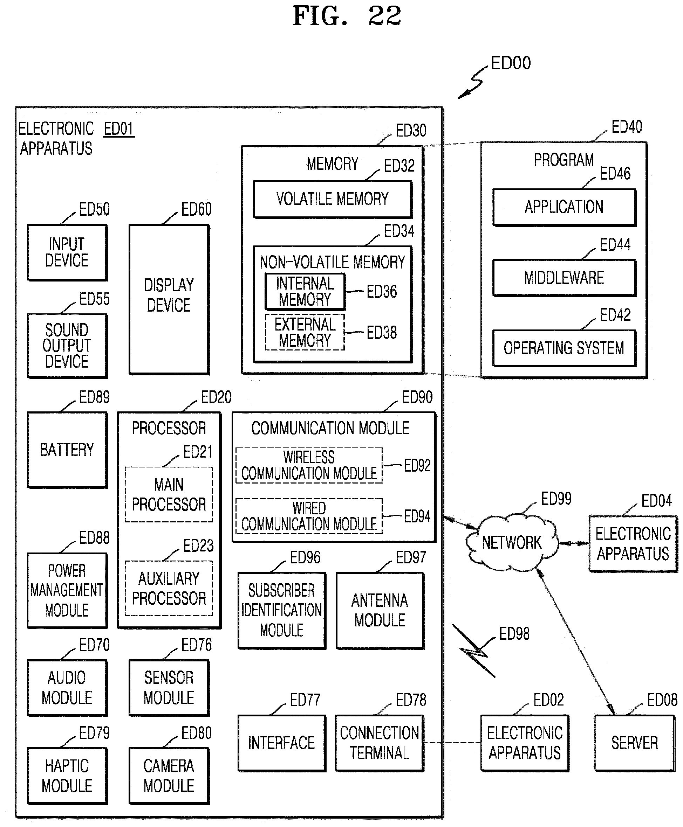

FIG. 22 is a block diagram showing an example of an electronic apparatus ED01 including an image sensor 1000. Referring to FIG. 22, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 a (central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic apparatus ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic apparatus ED01, from outside (a user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic apparatus (the electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (the electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (the electronic apparatus ED02, etc.). The connection terminal ED78 may include an HDMI connector, a USB connector, an SD card connector, and/or an audio connector (headphones connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (the electronic apparatus ED02, the electronic apparatus ED04, the server ED08, etc.), and execution of communication through the established communication channel. The communication module ED90 may be operated independently from the processor ED20 (application processor, etc.) and may include one or more communication processors that support the direct communication and/or the wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.). From among the communication modules, a corresponding communication module may communicate with another electronic apparatus via the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

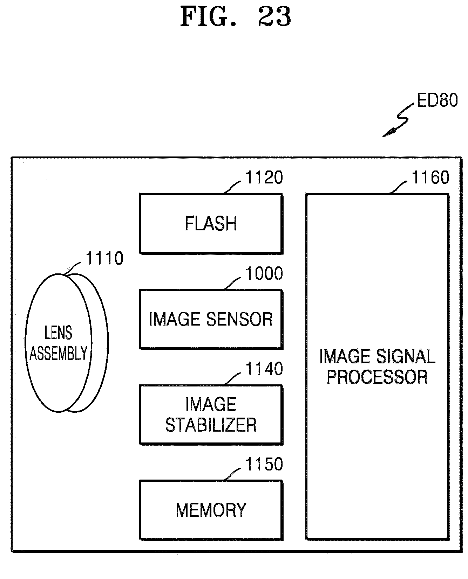

FIG. 23 is a block diagram showing an example of the camera module ED80 included in the electronic apparatus ED01 of FIG. 22. Referring to FIG. 23, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus ED01 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image processing may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80.

The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image processing by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 23, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

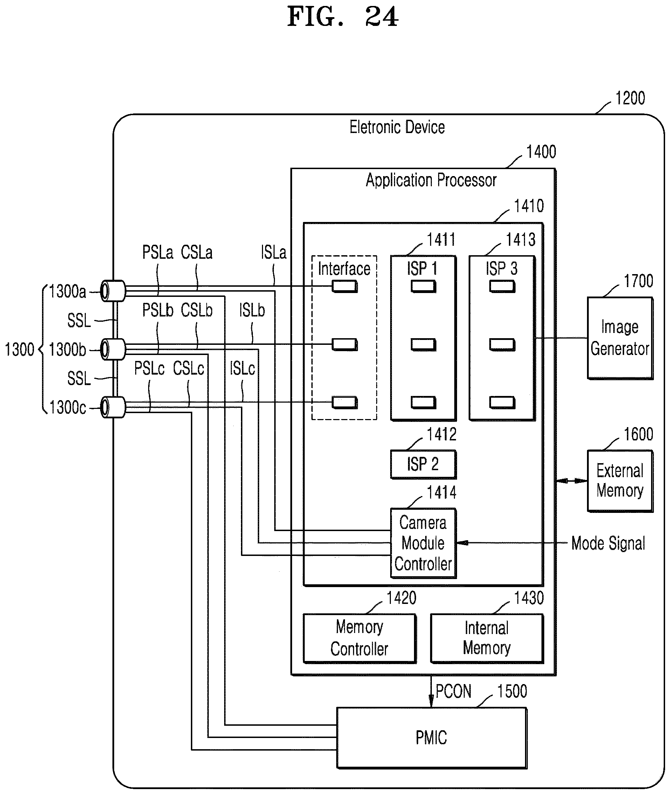

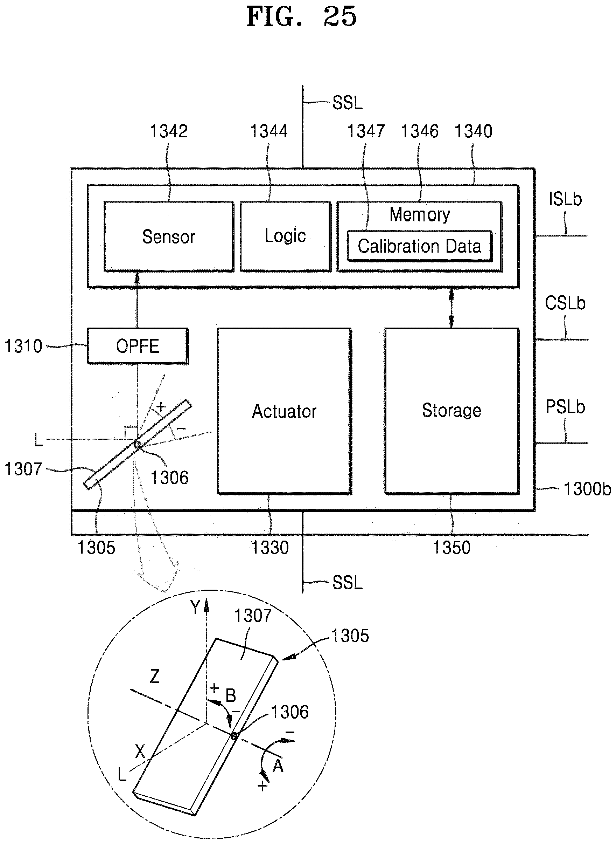

FIG. 24 is a block diagram of an electronic device 1200 including a multi-camera module, and FIG. 25 is a detailed block diagram of the camera module in the electronic device shown in FIG. 24.

Referring to FIG. 24, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is 4 or greater natural number) camera modules.

Hereinafter, detailed configuration of one camera module 1300b is described in detail below with reference to FIG. 25, but the description provided below may be also applied to the other camera modules 1300a and 1300c according to one or more embodiments.

Referring to FIG. 25, the camera module 1300b may include a prism 1305, an optical path folding element (OPFE) 1310, an actuator 1330, an image sensing device 1340, and a storage unit 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that is perpendicular to the first direction (X-direction). Also, the prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but the one or more embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some embodiments, the storage unit 1350 may be implemented as electrically erasable programmable read-only memory (EEPROM), but one or more embodiments are not limited thereto.

Referring to FIGS. 24 and 25, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 24, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1413. The image processor 1413 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

In detail, the image generator 1700 may generate an output image by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. Also, in some embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the internal memory 1430 provided therein or the external memory 1600 outside the application processor 1400, and after that, reads and decodes the encoded signal from the internal memory 1430 or the external memory1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate comprising a plurality of pixels configured to sense light, the plurality of pixels being are two-dimensionally provided;
a nano-photonic lens array comprising a plurality of meta-regions respectively corresponding to the plurality of pixels; and
an anti-reflection layer on a light incident surface of the nano-photonic lens array, the anti-reflection layer being configured to reduce a reflection loss and comprising a plurality of nano-patterns that are periodically and two-dimensionally provided,
wherein the plurality of meta-regions comprise a plurality of nano-structures configured to color-separate light that is incident on the nano-photonic lens array and focus the light onto each of the plurality of pixels, and
wherein, when a distance between a first nano-structure, from among the plurality of nano-structures, and a first nano-pattern, from among the plurality of nano-patterns, closest to the first nano-structure is g1 and a distance between a second nano-structure, from among the plurality of nano-structures, different from the first nano-structure, and a second nano-pattern, from among the plurality of nano-patterns, closest to the second nano-structure is g2, |g1 - g2|=Δg satisfies a condition Δg ≤ T/4, where T denotes an arrangement period of the plurality of nano-patterns.

2. The image sensor of claim 1, wherein, at a center portion of the nano-photonic lens array, g1 is 0.

3. The image sensor of claim 1 or 2, wherein, at a center portion of the nano-photonic lens array, the first nano-structure and the first nano-pattern closest to the first nano-structure are arranged such that the first nano-structure and the first nano-pattern do not overlap each other, and optionally wherein the first nano-structure is at a center portion of the nano-photonic lens array and g1 is T/2.

4. The image sensor of any preceding claim, wherein Δg is 0 with respect to an entire area of the nano-photonic lens array.

5. The image sensor of any preceding claim, wherein the first nano-structure is at a center portion of the nano-photonic lens array where incident light is perpendicularly incident, the second nano-structure is at a periphery portion of the nano-photonic lens array where the incident light is obliquely incident, and
wherein g1 is different from g2.

6. The image sensor of any preceding claim, wherein, at a center portion of the nano-photonic lens array where incident light is perpendicularly incident, the plurality of pixels and the plurality of meta-regions corresponding to each other are matched, and
wherein, at a periphery portion of the nano-photonic lens array where the incident light is obliquely incident, the plurality of meta-regions are shifted toward the center portion of the nano-photonic lens array with respect to corresponding pixels from among the plurality of pixels, and optionally wherein: at the periphery portion of the nano-photonic lens array, the plurality of nano-patterns of the anti-reflection layer are shifted toward the center portion of the nano-photonic lens array; and
wherein a deviation between a shifted distance of the plurality of meta-regions and a shifted distance of the plurality of nano-patterns is within ±1/4 of the arrangement period of the plurality of nano-patterns,
and further optionally wherein, in the entire area of the nano-photonic lens array, the shifted distance of the plurality of meta-regions and a shifted distance of the plurality of nano-patterns are equal to each other.

7. The image sensor of any preceding claim, wherein a pitch between the plurality of nano-structures is equal to a pitch between the plurality of nano-patterns.

8. The image sensor of any preceding claim, further comprising:
a color filter layer between the sensor substrate and the nano-photonic lens array; and
a planarization layer between the color filter layer and the nano-photonic lens array.

9. The image sensor of claim 8, wherein the color filter layer comprises a first color filter configured to transmit light of a first wavelength, a second color filter configured to transmit light of a second wavelength that is different from the first wavelength, a third color filter configured to transmit light of a third wavelength that is different from the first wavelength and the second wavelength, and a fourth color filter configured to transmit light of the first wavelength,
wherein the plurality of pixels comprise a first pixel corresponding to the first color filter, a second pixel corresponding to the second color filter, a third pixel corresponding to the third color filter, and a fourth pixel corresponding to the fourth color filter, and
wherein the plurality of meta-regions comprise a first meta-region corresponding to the first pixel, a second meta-region corresponding to the second pixel, a third meta-region corresponding to the third pixel, and a fourth meta-region corresponding to the fourth pixel.

10. The image sensor of claim 9, wherein, at a center portion of the nano-photonic lens array where incident light is perpendicularly incident, a boundary of the first pixel, a boundary of the first color filter, and a boundary of the first meta-region corresponding to one another are matched, a boundary of the second pixel, a boundary of the second color filter, and a boundary of the second meta-region corresponding to one another are matched, a boundary of the third pixel, a boundary of the third color filter, and a boundary of the third meta-region corresponding to one another are matched, and a boundary of the fourth pixel, a boundary of the fourth color filter, and a boundary of the fourth meta-region corresponding to one another are matched, and
wherein, at a periphery portion of the nano-photonic lens array where the incident light is obliquely incident, the first color filter, the second color filter, the third color filter, and the fourth color filter are shifted toward the center portion of the nano-photonic lens array by a first distance with respect to the first pixel, the second pixel, the third pixel, and the fourth pixel corresponding to the first color filter, the second color filter, the third color filter, and the fourth color filter, respectively, and the first meta-region, the second meta-region, the third meta-region, and the fourth meta-region are shifted toward the center portion of the nano-photonic lens array by a second distance that is greater than the first distance with respect to the first pixel, the second pixel, the third pixel, and the fourth pixel corresponding to the first meta-region, the second meta-region, the third meta-region, and the fourth meta-region, respectively, and optionally wherein: at the periphery portion of the nano-photonic lens array, the plurality of nano-patterns are shifted toward the center portion of the nano-photonic lens array by a third distance; and
wherein, in the entire area of the nano-photonic lens array, a condition d2 - T/4 ≤ d3 ≤ d2 + T/4 is satisfied, where d2 denotes the second distance and d3 denotes the third distance.

11. The image sensor of any preceding claim, wherein each nano-structure of the plurality of nano-structures comprise a first nano-structure layer and a second nano-structure layer on the first nano-structure layer, and
wherein g1 corresponds to a distance between the first nano-structure and the first nano-pattern included in the second nano-structure layer and g2 corresponds to a distance between the second nano-structure and the second nano-pattern included in the second nano-structure layer, and optionally wherein, at a periphery portion of the nano-photonic lens array where incident light is obliquely incident, the second nano-structure layer is shifted toward a center portion of the nano-photonic lens array.

12. The image sensor of any preceding claim, wherein the anti-reflection layer comprises a first anti-reflection layer and a second anti-reflection layer on the first anti-reflection layer,
wherein the first anti-reflection layer is a film structure and is on the nano-photonic lens array, and
wherein the second anti-reflection layer comprises the plurality of nano-patterns.

13. The image sensor of any preceding claim, wherein the anti-reflection layer further comprises a dielectric layer that is transparent with respect to visible ray, and the plurality of nano-patterns comprise holes formed through the dielectric layer.

14. The image sensor of any preceding claim, wherein the arrangement period of the plurality of nano-patterns is 150 nm to 300 nm, and a width or a diameter of each of the plurality of nano-patterns is 60% to 90% of the arrangement period of the plurality of nano-patterns.

15. An electronic apparatus comprising:
a lens assembly configured to form an optical image of a subject;
an image sensor according to any preceding claim configured to convert the optical image formed by the lens assembly into an electrical signal; and
at least one processor configured to process the electrical signal generated by the image sensor.
